(19) Europäisches Patentamt / European Patent Office / Office européen des brevets

(11) **EP 3 798 695 A1**

(12) **DEMANDE DE BREVET EUROPEEN**

(43) Date de publication:
**31.03.2021 Bulletin 2021/13**

(51) Int Cl.:
***G02B 5/02*** *(2006.01)*     ***B82Y 20/00*** *(2011.01)*

(21) Numéro de dépôt: **20198212.1**

(22) Date de dépôt: **24.09.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **27.09.2019 FR 1910726**

(71) Demandeur: **COMMISSARIAT À L'ÉNERGIE ATOMIQUE ET AUX ÉNERGIES ALTERNATIVES 75015 Paris (FR)**

(72) Inventeurs:
- **BOUTAMI, Salim 38054 GRENOBLE (FR)**
- **AVENTURIER, Bernard 38054 GRENOBLE (FR)**
- **GETIN, Stéphane 38054 GRENOBLE (FR)**
- **SUHM, Aurélien 38054 GRENOBLE (FR)**
- **JOLY, Pierre 38054 GRENOBLE (FR)**

(74) Mandataire: **Hautier, Nicolas Cabinet Hautier 20, rue de la Liberté 06000 Nice (FR)**

(54) **STRUCTURE DIFFUSIVE POUR SOURCE DE LUMIÈRE**

(57) L'invention concerne un diffuseur 3 destiné à être en regard d'une source de lumière 1 comprenant une couche de transmission 10 et une couche de diffusion 22, 23 destinée à diffuser une lumière émise par la source de lumière, le diffuseur étant caractérisé en ce que la couche de diffusion comprend une pluralité de structures métalliques 200, 200a, 200b, dites nanostructures métalliques, présentant des dimensions inférieures à une longueur d'onde de la lumière émise, lesdites nanostructures métalliques présentant des tailles variées et étant réparties au sein de la couche de diffusion de sorte que des nanostructures métalliques adjacentes présentent entre elles des distances variées et de préférence inférieures à la longueur d'onde de la lumière émise.
L'invention concerne également un procédé de fabrication d'un tel diffuseur, et un système d'affichage comprenant un tel diffuseur.

FIG. 12

**Description**

DOMAINE TECHNIQUE

L'invention concerne le domaine de l'optique. Elle trouve pour application particulièrement avantageuse l'amélioration de la diffusivité de sources de lumière pixellisées telles que des diodes électroluminescentes (LED).

ÉTAT DE LA TECHNIQUE

Une source de lumière peut être étendue ou ponctuelle.

Une source de lumière ponctuelle, également dénommée source de lumière pixellisée, peut être utilisée dans des systèmes de visualisation ou d'affichage. En particulier, une pluralité de sources de lumière ponctuelles adjacentes permet de former des pixels d'un écran. Une telle source de lumière ponctuelle peut présenter des dimensions de l'ordre de quelques dizaines de microns. Les diodes électroluminescentes (LED) peuvent avantageusement former ces sources de lumière ponctuelles.

Une LED présente généralement un angle d'émission relativement restreint. Elle se caractérise par une directivité élevée.

Dans certaines applications cependant, il peut être nécessaire d'avoir une source de lumière ponctuelle présentant une faible directivité, avec un grand angle d'émission. C'est le cas pour des écrans d'affichage 3D par exemple.

Une solution pour rendre une LED peu directive consiste à ajouter une structure diffusive à la LED, de façon à diffuser la lumière émise par la LED dans toutes les directions.

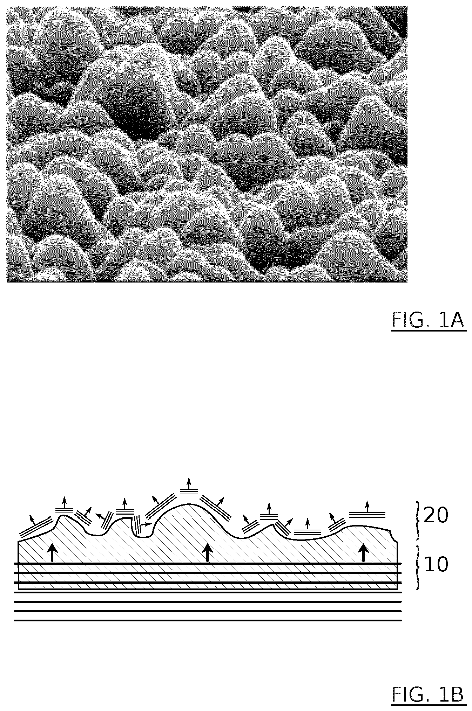

De façon connue, une telle structure diffusive peut se présenter sous forme d'un film diffuseur diélectrique comprenant des corrugations diélectriques aléatoires (figure 1A). Les pseudo-périodes et/ou les dimensions de ces corrugations peuvent atteindre plusieurs microns, voire plusieurs dizaines de microns (figure 1A). Elles sont notamment plus grandes que la longueur d'onde d'émission de la LED.

Le fonctionnement d'un tel film diffuseur diélectrique n'est donc pas directement basé sur un phénomène de diffusion de la lumière. Le film diffuseur diélectrique génère dans ce cas de multiples réfractions de la lumière sur les surfaces d'inclinaisons différentes des corrugations, tel qu'illustré à la figure 1B. La lumière est donc réfractée par le film diffuseur, dit film diffuseur réfractif, dans une multitude de directions différentes.

Ce phénomène de réfraction de la lumière statistiquement dans toutes les directions reproduit, par effet de moyennage, un phénomène de diffusion isotrope. Ce type de film diffuseur réfractif fonctionne très bien pour des sources de lumière étendues.

Cependant, pour des sources de lumière pixélisées, en particulier pour des sources pixellisées dont les dimensions sont inférieures ou égales à 15μm, ce type de film diffuseur réfractif ne permet pas de reproduire un phénomène de diffusion isotrope pour chacune des sources.

De telles sources pixellisées agencées en regard de ce type de film diffuseur réfractif ne sont plus associées chacune à une multitude de corrugations.

L'effet de moyennage obtenu avec une source étendue n'est donc plus obtenu avec une source ponctuelle. Dans ce cas, la lumière émise par une source ponctuelle est réfractée dans un nombre limité de directions, voire dans une seule direction. Le phénomène de diffusion n'est donc pas bien reproduit. Cette réfraction est même particulièrement anisotrope. La source ponctuelle, par exemple une LED formant un pixel d'un écran d'affichage, reste très directive avec ce type de film diffuseur réfractif.

Dans ce cas, la ou les directions de réfraction varient en outre d'un pixel à un autre. Pour un écran dont les pixels sont des LED émettant toutes une lumière de même intensité lumineuse, des variations d'intensité lumineuse dues au film diffuseur réfractif peuvent donc être perçues sur l'écran, selon la direction d'observation, ce qui est naturellement fortement indésirable.

La présente invention vise à pallier au moins partiellement certains des inconvénients mentionnés ci-dessus.

En particulier, un objet de la présente invention est de proposer un film diffuseur ou diffuseur permettant d'optimiser la diffusion de la lumière émise par une source de lumière, de préférence par une source de lumière ponctuelle.

Un autre objet de la présente invention est de proposer un procédé de fabrication d'un tel diffuseur.

Un autre objet de la présente invention est de proposer un système comprenant au moins un tel diffuseur et au moins une source de lumière pixellisée, coopérant l'un avec l'autre.

Les autres objets, caractéristiques et avantages de la présente invention apparaîtront à l'examen de la description suivante et des dessins d'accompagnement. Il est entendu que d'autres avantages peuvent être incorporés.

RÉSUMÉ

Pour atteindre les objectifs mentionnés ci-dessus, un aspect de la présente invention concerne un diffuseur destiné à recevoir une lumière émise par une source de lumière visible, ledit diffuseur comprenant une couche de transmission transparente à la lumière émise et une couche de diffusion destinée à diffuser la lumière émise par la source de lumière, et de préférence supportée au moins en partie par la couche de transmission.

Avantageusement, la couche de diffusion comprend une pluralité de nanostructures métalliques présentant chacune, en projection dans un plan d'extension principal, des première et deuxième dimensions selon respectivement des première et deuxième directions orthogonales du plan d'extension principal, lesdites première et deuxième dimensions étant inférieures à 650 nm.

Ces nanostructures métalliques sont réparties au sein de la couche de diffusion de sorte que des nanostructures métalliques adjacentes présentent entre elles des distances de séparation variées. Ces nanostructures métalliques sont en outre dimensionnées de sorte à présenter entre elles des dimensions variées parmi les premières et les deuxièmes dimensions.

Ainsi le diffuseur selon l'invention comprend une pluralité de nanostructures présentant chacune au moins deux dimensions inférieures à 650 nm, de préférence inférieures à 500 nm et de préférence inférieures à 400 nm. Les premières et deuxièmes dimensions des nanostructures sont donc inférieures à au moins une partie du spectre de longueurs d'onde de la lumière visible. Cela permet d'obtenir un phénomène de diffusion de cette lumière, contrairement au diffuseur réfractif présenté plus haut.

En outre, ces premières et deuxièmes dimensions sont prises selon deux axes orthogonaux dans le plan d'extension principal. Cela permet d'obtenir ce phénomène de diffusion selon au moins deux orientations qui, en moyenne, couvrent le mieux un plan d'observation dans lequel se trouve un observateur. La disposition relative orthogonale correspond au meilleur compromis possible avec deux orientations. Cela permet d'améliorer l'isotropie de la diffusion.

Ces nanostructures sont en un matériau métallique. Un tel matériau métallique présente notamment un indice de réfraction au moins deux fois supérieur à celui de la couche de transmission transparente à la lumière émise. Cela permet d'obtenir un phénomène de diffusion significatif, contrairement au diffuseur réfractif présenté plus haut. L'efficacité de la diffusion est améliorée.

Les nanostructures forment de préférence une simple couche de particules sur la couche de transmission. La lumière qui traverse cette simple couche en incidence normale ou quasi-normale est ainsi faiblement atténuée. La quasi-totalité de la lumière incidente peut ainsi être efficacement diffusée.

Par ailleurs, ces nanostructures, en particulier les nanostructures adjacentes, présentent entre elles des dimensions et des distances de séparation variées. Cela permet d'éviter une diffusion de la lumière selon une direction privilégiée par effet de réseau. Cela permet d'améliorer l'isotropie de la diffusion. Les nanostructures sont de préférence réparties de façon aléatoire ou désordonnée.

Ainsi, la présente invention prévoit d'intégrer dans la couche de diffusion des nanostructures métalliques permettant non seulement de diffuser la lumière, mais aussi de rendre une telle diffusion efficace et isotrope.

Les développements menés dans le cadre de la présente invention ont montré que la combinaison des caractéristiques de ces nanostructures permettait d'obtenir un effet synergique, conduisant à une diffusion optimisée, en particulier pour des sources de lumière ponctuelles ou pixellisées.

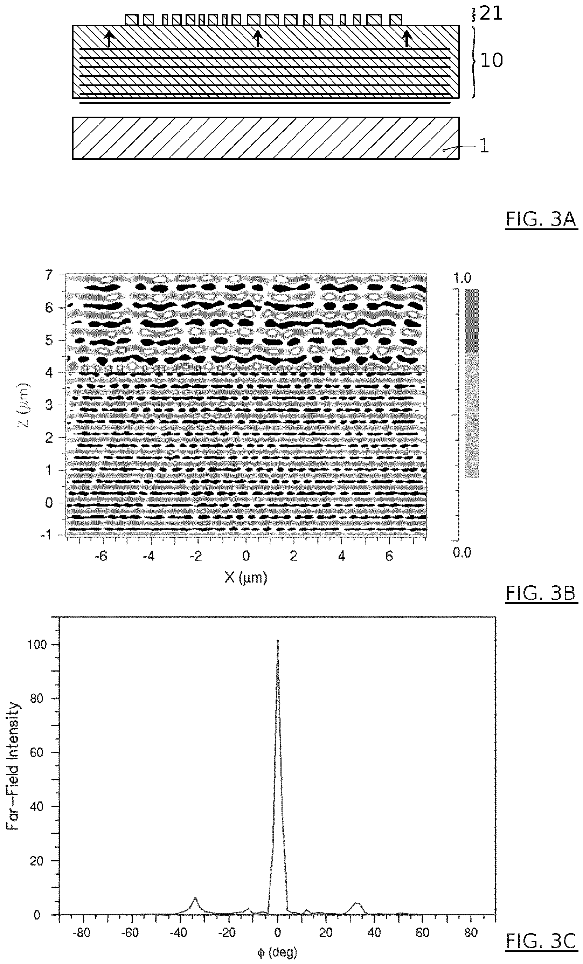

Une solution alternative, qui diffère de la solution retenue dans le cadre de la présente invention mais qui aurait pu être mise en œuvre, consiste en un diffuseur comprenant une couche de transmission et une couche de diffusion à base de nanostructures diélectriques, tel qu'illustré à la figure 3A.

Cette solution alternative n'a pas été retenue dans le cadre de la présente invention car il a été identifié que les nanostructures diélectriques ne permettent pas une diffusion efficace de la lumière. Les performances de cette solution alternative sont détaillées dans la suite au travers de résultats de simulation.

Les développements ayant conduit à la présente invention ont donc montré qu'il est essentiel de prévoir une couche de diffusion à base de nanostructures métalliques.

Un autre aspect de la présente invention concerne un diffuseur destiné à recevoir une lumière émise par une source de lumière visible, ledit diffuseur comprenant une couche de transmission transparente à la lumière émise et une couche de diffusion destinée à diffuser ladite lumière émise, dans lequel la couche de diffusion comprend au moins une nanostructure métallique présentant, en projection dans un plan d'extension principal, des première et deuxième dimensions selon respectivement des première et deuxième directions orthogonales du plan d'extension principal, inférieures à 650 nm.

Avantageusement, ce diffuseur comprend en outre une couche de focalisation configurée pour focaliser la lumière émise sur l'au moins une nanostructure métallique. Cela permet d'augmenter le diagramme angulaire de diffusion.

Des résultats avantageux liés au diffuseur selon les différents aspects de l'invention sont présentés dans la suite.

La présente invention concerne également un procédé de fabrication d'un diffuseur comprenant au moins une couche de diffusion destinée à diffuser une lumière émise par une source de lumière visible et comprenant une pluralité de nanostructures métalliques.

Ce procédé comprend les étapes suivantes :

- Fournir un support en un matériau transparent à la lumière émise et présentant une face de support,
- Former sur la face de support une pluralité de nanostructures métalliques, ou au moins une nanostructure métallique, présentant chacune en projection dans un plan d'extension principal parallèle à la face de support des première et deuxième dimensions selon respectivement des première et deuxième directions orthogonales du plan d'extension principal, lesdites première et deuxième dimensions étant inférieures à 650 nm.

Les nanostructures métalliques de la pluralité de nanostructures métalliques sont réparties sur le support de sorte que des nanostructures métalliques adjacentes présentent entre elles des distances de séparation variées. Ces nanostructures métalliques sont en outre dimensionnées de sorte à présenter entre elles des dimensions variées parmi les premières et les deuxièmes dimensions.

La présente invention concerne également un système comprenant au moins un diffuseur selon l'invention et une pluralité de sources de lumières pixellisées, agencés l'un à l'autre. L'au moins un diffuseur est configuré pour coopérer avec l'au moins une source de lumière ponctuelle de façon à diffuser une lumière émise par celle-ci.

Un tel système peut avantageusement être utilisé pour la réalisation d'écran d'affichage, en particulier pour des écrans 3D.

BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

- La FIGURE 1A est une image par microscopie électronique à balayage d'un film diffuseur diélectrique selon l'art antérieur.
- La FIGURE 1B illustre schématiquement en coupe un fonctionnement du film diffuseur diélectrique de la figure 1A.
- La FIGURE 2A illustre schématiquement un diffuseur comprenant une couche de transmission seule.
- La FIGURE 2B montre une cartographie du champ électromagnétique obtenue par simulation pour une transmission de lumière au travers du diffuseur de la figure 2A.
- La FIGURE 2C montre un diagramme angulaire obtenu par simulation pour une transmission de lumière au travers du diffuseur de la figure 2A.
- La FIGURE 3A illustre schématiquement un diffuseur selon une solution alternative identifiée dans le cadre du développement de la présente invention, comprenant une couche de transmission et une couche de diffusion à base de nanostructures diélectriques désordonnées.
- La FIGURE 3B montre une cartographie du champ électromagnétique obtenue par simulation pour une transmission de lumière au travers du diffuseur de la figure 3A.
- La FIGURE 3C montre un diagramme angulaire obtenu par simulation pour une transmission de lumière au travers du diffuseur de la figure 3A.
- La FIGURE 4A illustre schématiquement un diffuseur comprenant une couche de transmission et une couche de diffusion à base de nanostructures métalliques désordonnées, selon un mode de réalisation de la présente invention.
- La FIGURE 4B montre une cartographie du champ électromagnétique obtenue par simulation pour une transmission de lumière au travers du diffuseur de la figure 4A.
- La FIGURE 4C montre un diagramme angulaire obtenu par simulation pour une transmission de lumière au travers du diffuseur de la figure 4A.
- La FIGURE 5A illustre schématiquement un diffuseur comprenant une couche de transmission et une couche de focalisation.
- La FIGURE 5B montre une cartographie du champ électromagnétique obtenue par simulation pour une transmission de lumière au travers du diffuseur de la figure 5A.
- La FIGURE 5C montre un diagramme angulaire obtenu par simulation pour une transmission de lumière au travers du diffuseur de la figure 5A.
- La FIGURE 6A illustre schématiquement un diffuseur comprenant une couche de transmission, une couche de focalisation et une couche de diffusion à base d'une nanostructure métallique, selon un mode de réalisation de la présente invention.
- La FIGURE 6B montre une cartographie du champ électromagnétique obtenue par simulation pour une transmission de lumière au travers du diffuseur de la figure 6A.
- La FIGURE 6C montre un diagramme angulaire obtenu par simulation pour une transmission de lumière au travers du diffuseur de la figure 6A.
- La FIGURE 7A illustre schématiquement un diffuseur comprenant une couche de transmission, une couche de focalisation, une couche de réflexion et une couche de diffusion à base d'une nanostructure métallique, selon un mode de réalisation de la présente invention.
- La FIGURE 7B montre une cartographie du champ électromagnétique obtenue par simulation pour une transmission de lumière au travers du diffuseur de la figure 7A.
- La FIGURE 7C montre un diagramme angulaire obtenu par simulation pour une transmission de lumière au travers du diffuseur de la figure 7A.
- La FIGURE 8A illustre schématiquement un diffuseur comprenant une couche de transmission, une couche de focalisation, une couche de réflexion et une couche de diffusion à base d'une pluralité de nanostructures métalliques, selon un mode de réalisation de la présente invention.
- La FIGURE 8B montre une cartographie du champ électromagnétique obtenue par simulation pour une transmission de lumière au travers du diffuseur de la figure 8A.
- La FIGURE 8C montre un diagramme angulaire obtenu par simulation pour une transmission de lumière au travers du diffuseur de la figure 8A.

- La FIGURE 9A illustre schématiquement en coupe transverse un diffuseur comprenant une couche de transmission et une couche de diffusion à base d'une pluralité de nanostructures métalliques, selon un mode de réalisation de la présente invention.

- La FIGURE 9B illustre schématiquement en vue de dessus un diffuseur selon le mode de réalisation de la figure 9A.

- La FIGURE 10A illustre schématiquement en coupe transverse un diffuseur comprenant une couche de transmission, une couche de focalisation et une couche de diffusion à base d'une nanostructure métallique, selon un mode de réalisation de la présente invention.

- La FIGURE 10B illustre schématiquement en coupe transverse un diffuseur comprenant une couche de transmission, une couche de focalisation et une couche de diffusion à base d'une nanostructure métallique, selon un autre mode de réalisation de la présente invention.

- Les FIGURES 10C à 10E illustrent schématiquement, en vue de dessus, différentes couches de focalisation d'un diffuseur selon le mode de réalisation de la figure 10B.

- La FIGURE 11 illustre schématiquement en coupe transverse un diffuseur comprenant une couche de transmission, une couche de focalisation, une couche de réflexion et une couche de diffusion à base d'une nanostructure métallique, selon un mode de réalisation de la présente invention.

- La FIGURE 12 illustre schématiquement en coupe transverse un diffuseur comprenant une couche de transmission, une couche de focalisation, une couche de réflexion et une couche de diffusion à base d'une pluralité de nanostructures métalliques, selon un mode de réalisation de la présente invention.

- La FIGURE 13A illustre schématiquement un diffuseur comprenant une couche de transmission, une couche de focalisation, une couche de réflexion et une couche de diffusion à base d'une nanostructure métallique, selon un mode de réalisation de la présente invention et illuminé par une lumière de longueur d'onde A = 450 nm.

- La FIGURE 13B montre une cartographie du champ électromagnétique obtenue par simulation pour une transmission de lumière de longueur d'onde A = 450 nm au travers du diffuseur de la figure 13A.

- La FIGURE 13C montre un diagramme angulaire obtenu par simulation pour une transmission de lumière de longueur d'onde A = 450 nm au travers du diffuseur de la figure 13A.

- La FIGURE 14A illustre schématiquement un diffuseur comprenant une couche de transmission, une couche de focalisation, une couche de réflexion et une couche de diffusion à base d'une nanostructure métallique, selon un mode de réalisation de la présente invention et illuminé par une lumière de longueur d'onde A = 550 nm.

- La FIGURE 14B montre une cartographie du champ électromagnétique obtenue par simulation pour une transmission de lumière de longueur d'onde A = 550 nm au travers du diffuseur de la figure 14A.

- La FIGURE 14C montre un diagramme angulaire obtenu par simulation pour une transmission de lumière de longueur d'onde A = 550 nm au travers du diffuseur de la figure 14A.

- La FIGURE 15A illustre schématiquement un diffuseur comprenant une couche de transmission, une couche de focalisation, une couche de réflexion et une couche de diffusion à base d'une nanostructure métallique, selon un mode de réalisation de la présente invention et illuminé par une lumière de longueur d'onde A = 650 nm.

- La FIGURE 15B montre une cartographie du champ électromagnétique obtenue par simulation pour une transmission de lumière de longueur d'onde $\lambda$ = 650 nm au travers du diffuseur de la figure 15A.

- La FIGURE 15C montre un diagramme angulaire obtenu par simulation pour une transmission de lumière de longueur d'onde $\lambda$ = 650 nm au travers du diffuseur de la figure 15A.

- La FIGURE 16A illustre schématiquement un diffuseur comprenant une couche de transmission, une couche de focalisation, une couche de réflexion et une couche de diffusion à base d'une nanostructure métallique, selon un mode de réalisation de la présente invention présentant une configuration idéale et illuminé de façon idéale.

- La FIGURE 16B illustre schématiquement un diffuseur comprenant une couche de transmission, une couche de focalisation, une couche de réflexion et une couche de diffusion à base d'une nanostructure métallique, selon un mode de réalisation de la présente invention présentant une configuration non idéale et illuminé de façon idéale.

- La FIGURE 16C montre un diagramme angulaire obtenu par simulation pour une transmission de lumière au travers du diffuseur de la figure 16B présentant une distance d=3$\mu$m entre la couche de réflexion et la couche de diffusion et une distance H=12$\mu$m entre la couche de réflexion et la couche de focalisation.

- La FIGURE 16D montre un diagramme angulaire obtenu par simulation pour une transmission de lumière au travers du diffuseur de la figure 16B présentant une distance d=7$\mu$m entre la couche de réflexion et la couche de diffusion et une distance H=8$\mu$m entre la couche de réflexion et la couche de focalisation.

- La FIGURE 17A illustre schématiquement un diffuseur comprenant une couche de transmission, une couche de focalisation, une couche de réflexion et une couche de diffusion à base d'une nanostructure métallique, selon un mode de réalisation de la présente invention présentant une configuration idéale et illuminé de façon idéale.
- La FIGURE 17B illustre schématiquement un diffuseur comprenant une couche de transmission, une couche de focalisation, une couche de réflexion et une couche de diffusion à base d'une nanostructure métallique, selon un mode de réalisation de la présente invention présentant une configuration idéale et illuminé de façon non idéale.
- La FIGURE 17C montre un diagramme angulaire obtenu par simulation pour une transmission de lumière au travers du diffuseur de la figure 17B présentant une distance d=3μm entre la couche de réflexion et la couche de diffusion et une distance H=12μm entre la couche de réflexion et la couche de focalisation.
- La FIGURE 17D montre un diagramme angulaire obtenu par simulation pour une transmission de lumière au travers du diffuseur de la figure 17B présentant une distance d=7μm entre la couche de réflexion et la couche de diffusion et une distance H=8μm entre la couche de réflexion et la couche de focalisation.
- Les FIGURES 18A à 18D illustrent schématiquement des étapes d'un procédé de fabrication d'un diffuseur selon un mode de réalisation de l'invention
- Les FIGURES 19A à 19C illustrent schématiquement des étapes d'un procédé de fabrication d'un diffuseur comprenant une couche de diffusion à base d'une nanostructure métallique, une couche de transmission et une couche de focalisation comprenant une microlentille, selon un mode de réalisation de l'invention.
- Les FIGURES 20A à 20G illustrent schématiquement des étapes de formation d'une microlentille pour un diffuseur comprenant une couche de diffusion à base d'une pluralité de nanostructures métalliques, une couche de transmission, une couche de réflexion et une couche de focalisation comprenant la microlentille, selon un mode de réalisation de l'invention.
- Les FIGURES 21A à 21F illustrent schématiquement des étapes d'un procédé de fabrication d'un diffuseur comprenant une couche de diffusion à base d'une pluralité de nanostructures métalliques, une couche de transmission, une couche de réflexion et une couche de focalisation comprenant une microlentille, selon un mode de réalisation de l'invention.
- Les FIGURES 22A à 22E illustrent schématiquement des étapes de formation d'une lentille de Fresnel pour un diffuseur comprenant une couche de diffusion à base d'une pluralité de nanostructures métalliques, une couche de transmission, une couche de réflexion et une couche de focalisation comprenant la lentille de Fresnel, selon un mode de réalisation de l'invention.
- La FIGURE 23 montre un agencement d'une pluralité de diffuseurs selon un mode de réalisation de l'invention.

- La FIGURE 24 montre un système comprenant une pluralité de diffuseurs agencée à une pluralité de LED, selon un mode de réalisation de l'invention.
- La FIGURE 25 montre un système configuré pour un affichage 3D comprenant un écran haute résolution associé à une matrice de microlentilles.
- La FIGURE 26 montre un système configuré pour un affichage 3D comprenant une pluralité de micro-écrans associée à une pluralité de systèmes de projection et à au moins un diffuseur, et une matrice de microlentilles.
- La FIGURE 27 montre un système de projection du système d'affichage 3D illustré à la figure 26, selon un mode de réalisation.
- La FIGURE 28 montre un dimensionnement d'une partie du système d'affichage 3D illustré à la figure 26.
- La FIGURE 29 montre le système d'affichage 3D illustré à la figure 26 comprenant une pluralité de diffuseurs selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions des différentes couches et structures des diffuseurs ne sont pas représentatives de la réalité. Par souci de clarté, un même jeu de référence applicable aux figures d'une même série n'est pas nécessairement reporté sur toutes les figures de la série. Il est entendu que, pour l'identification des éléments d'une figure d'une série donnée, le lecteur pourra se reporter aux autres figures de cette série. Une série de figures comprend typiquement les figures portant une même référence numérique associée à un caractère alphabétique.

## DESCRIPTION DÉTAILLÉE

Avant d'entamer une revue détaillée de modes de réalisation de l'invention, il est rappelé que l'invention comprend notamment les caractéristiques optionnelles ci-après pouvant être utilisées en association ou alternativement. Sauf incompatibilité, il est entendu que le diffuseur selon ses différents aspects, le procédé de fabrication, et le système d'affichage peuvent comprendre, *mutatis mutandis,* les caractéristiques suivantes :
Selon un exemple, les nanostructures métalliques adjacentes sont séparées les unes des autres par des distances de séparation différentes entre elles.
Selon un exemple, au moins certaines des nanostructures métalliques adjacentes présentent des distances de séparation inférieures à 500 nm, et au moins certaines autres des nanostructures métalliques adjacentes présentent des distances de séparation supérieures à 600 nm.

Selon un exemple, les distances de séparation entre deux nanostructures métalliques adjacentes varient jusqu'à 200%, de préférence jusqu'à 300% et de préférence jusqu'à 500% au sein de la couche de diffusion.

Selon un exemple, les distances de séparation entre nanostructures métalliques adjacentes sont inférieures à une longueur d'onde d'intérêt de la lumière émise.

Selon un exemple, les première et deuxième dimensions des nanostructures métalliques sont comprises entre 100 nm et 500 nm.

Selon un exemple, pour une même nanostructure, les première et deuxième dimensions des nanostructures métalliques sont sensiblement égales entre elles.

Selon un exemple, pour au moins certaines nanostructures métalliques de la pluralité de nanostructures métalliques, les dimensions variées prises parmi les premières et les deuxièmes dimensions sont inférieures à 250 nm, et pour au moins certaines autres nanostructures métalliques de la pluralité de nanostructures, les dimensions variées prises parmi les premières et les deuxièmes dimensions sont supérieures à 350 nm.

Selon un exemple, les dimensions variées prises parmi les premières et les deuxièmes dimensions varient jusqu'à 200%, de préférence jusqu'à 300% et de préférence jusqu'à 500% au sein de la couche de diffusion.

Selon un exemple, au sein de la couche de diffusion, à la fois les premières dimensions et les deuxièmes dimensions varient. Alternativement, au sein de la couche de diffusion, seules les premières dimensions ou seules les deuxièmes dimensions varient.

Selon un exemple, les premières dimensions varient proportionnellement aux deuxièmes dimensions.

Selon un exemple, en projection dans le plan d'extension principal, les nanostructures métalliques présentent chacune une surface, et les surfaces des nanostructures métalliques ne sont pas égales ou tout au moins ne sont pas toutes égales. La variation des surfaces des nanostructures métalliques au sein de la couche de diffusion peut être telle que $S_{max} \geq x*S_{min}$, avec $S_{max}$ et $S_{min}$ étant respectivement les surfaces maximale et minimale au sein de la couche de diffusion, et x = 2, de préférence x = 3 et de préférence x = 5.

Selon un exemple, le diffuseur comprend en outre une couche de focalisation configurée pour focaliser la lumière émise sur au moins une nanostructure métallique de la pluralité de nanostructures métalliques. Cette couche de focalisation est de préférence située sur la couche de transmission, d'un côté opposé au côté de la couche de transmission supportant la couche de diffusion.

Selon un exemple, la couche de focalisation comprend l'une parmi une microlentille réfractive et une lentille de Fresnel.

Selon un exemple, le diffuseur comprend en outre une couche de réflexion située entre la couche de diffusion et la couche de focalisation au sein de la couche de transmission, ladite couche de réflexion présentant au moins une ouverture en regard de la nanostructure métallique sur laquelle la lumière émise est focalisée. La couche de réflexion est de préférence parallèle à la couche de diffusion.

Selon un exemple, l'ouverture présente en projection dans le plan d'extension principal une dimension d'extension principale W telle que : $W \geq (D.d)/(H+d)$ où D est une dimension d'extension principale du diffuseur, d est une distance séparant la couche de diffusion de la couche de réflexion, H est une distance séparant la couche de réflexion de la couche de focalisation.

Selon un exemple, le diffuseur présente en projection dans le plan d'extension principal une dimension d'extension principale D comprise entre 5 $\mu$m et 30 $\mu$m.

Selon un exemple, les nanostructures métalliques présentent un indice de réfraction au moins deux fois supérieur à celui de la couche de transmission.

Selon un exemple, la couche de diffusion présente une épaisseur h comprise entre 100 nm et 500 nm, l'épaisseur h étant prise selon une direction perpendiculaire audit plan principal d'extension.

Selon un exemple, au moins une partie des nanostructures métalliques sont en au moins un métal pris parmi l'aluminium, le tungstène, le cuivre, l'argent, l'or.

Selon un exemple, le système d'affichage comprend :

- un écran, de préférence à très haute résolution, comprenant une pluralité de micro-écrans comprenant chacun une pluralité de pixels,
- une pluralité de systèmes de projection associée à la pluralité de micro-écrans,
- une pluralité de diffuseurs, chaque diffuseur étant associé à au moins un pixel des pluralités de pixels des micro-écrans, et
- une matrice de microlentilles associée à la pluralité de diffuseurs.

Selon un exemple, le procédé comprend en outre une étape de dépôt sur la pluralité de nanostructures métalliques d'un matériau transparent à la lumière émise et enveloppant les nanostructures métalliques. Selon un exemple, le procédé comprend en outre une étape de planarisation de la pluralité de nanostructures métalliques, configurée pour former une couche de diffusion composite comprenant le matériau transparent à la lumière émise enveloppant les nanostructures métalliques, de sorte que ladite couche de diffusion composite présente une face planarisée.

Selon un exemple, le procédé comprend en outre la formation d'une couche de transmission sur la face planarisée, ladite couche de transmission présentant une face de transmission opposée à la face planarisée et destinée à être en regard de la source de lumière.

Selon un exemple, le procédé comprend en outre la formation d'une couche de focalisation s'étendant sur la face de transmission, ladite couche de focalisation étant destinée à focaliser la lumière émise sur au moins une nanostructure métallique de la pluralité de nanostructures métalliques.

Selon un exemple, la couche de focalisation est formée par une microlentille réfractive, en particulier une microlentille réfractive en un matériau transparent à la lumière émise.

Selon un exemple la couche de focalisation est formée par une lentille de Fresnel.

Selon un exemple, le procédé comprend en outre la formation d'une couche de réflexion au sein de la couche de transmission, entre la couche de diffusion et la couche de focalisation, ladite couche de réflexion présentant au moins une ouverture en regard de l'au moins une nanostructure métallique sur laquelle la lumière émise est destinée à être focalisée par la couche de focalisation. La couche de réflexion est de préférence parallèle à la couche de diffusion.

Dans la présente demande de brevet, il est fait référence à un plan d'extension principal. Ce plan d'extension principal est le plan xy du repère orthonormé illustré sur les figures.

Dans la présente demande de brevet, on parlera préférentiellement d'épaisseur pour une couche et de hauteur pour un dispositif. L'épaisseur et la hauteur sont prises selon une direction z normale au plan d'extension principal.

Le terme nanostructure désigne en particulier un objet solide dont au moins une dimension est nanométrique, c'est-à-dire strictement inférieure à 1 $\mu$m. Dans le cadre de l'invention, la ou les nanostructures présentent chacune, en projection dans le plan d'extension principal, deux dimensions nanométriques, inférieures à quelques centaines de nanomètres, soit inférieures à une longueur d'onde d'intérêt de la lumière émise.

On entend par « taille » d'une nanostructure :

- soit la distance maximale entre deux points de la nanostructure prise dans un plan parallèle au plan d'extension principal, dite dimension critique,
- soit la surface de la projection de la nanostructure dans le plan d'extension principal,
- soit le volume de cette nanostructure.

La taille d'une nanostructure correspond donc à une ou plusieurs dimensions représentatives de la nanostructure. La taille d'une nanostructure sphérique peut par exemple correspondre au diamètre de la sphère.

On entend par « distance de séparation » entre deux nanostructures adjacentes la plus petite distance en projection dans le plan d'extension principal xy séparant deux nanostructures adjacentes. Les distances de séparation séparant deux nanostructures adjacentes $200_i$ et $200_j$ sont notées $d_{ij}$, avec i et j des entiers naturels.

Dans le cadre de l'invention, les nanostructures présentent des tailles et/ou des distances entre elles variées. Cela signifie que les tailles de ces nanostructures et/ou les distances entre ces nanostructures ne sont pas toutes égales. Par exemple, un écart-type d'au moins 15% est requis sur les tailles de ces nanostructures et/ou les distances entre ces nanostructures.

Dans la présente invention, le diffuseur est en particulier destiné à être agencé avec des sources de lumières ponctuelles, en particulier des LED.

Une source de lumière ponctuelle s'entend d'une source présentant des dimensions en projection dans le plan d'extension principal inférieures à quelques dizaines de microns, en particulier inférieures à 30 $\mu$m, et de préférence inférieures ou égales à 15 $\mu$m.

L'invention peut cependant être mise en œuvre plus largement pour différentes sources de lumière, par exemple des sources étendues.

Les sources de lumière ponctuelles ou étendues peuvent être polychromatiques ou monochromatiques. La lumière émise par ces sources est de préférence une lumière visible.

Dans le cas d'une source polychromatique, la longueur d'onde d'intérêt de la lumière émise par cette source peut être la plus petite longueur d'onde émise par la source. Elle peut éventuellement être la plus petite longueur d'onde émise par la source et reçue par la couche de diffusion, dans le cas où un élément intermédiaire entre la source et la couche de diffusion (par exemple un filtre ou la couche de transmission elle-même) filtre une partie de cette lumière, intentionnellement ou non. Elle peut également s'entendre d'une gamme de longueurs d'ondes de quelques dizaines de nanomètres, par exemple de l'ordre de 100 nm ou moins.

Dans le cas d'une source monochromatique ou quasi-monochromatique, la longueur d'onde d'intérêt est l'unique longueur d'onde émise par cette source ou la longueur d'onde principalement émise par cette source.

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément.

Les étapes de formation des différentes couches et régions s'entendent au sens large : elles peuvent être réalisées en plusieurs sous-étapes qui ne sont pas forcément strictement successives.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une couche de diffusion à base de nanostructures métalliques peut par exemple comprendre des nanostructures en tungstène (W) ou des nanostructures en tungstène (W) et en aluminium (Al), ou encore des nanostructures en tungstène (W) et un matériau d'encapsulation transparent.

On entend par une couche ou un matériau « transparent à la lumière émise ou à la longueur d'onde d'intérêt » une couche ou un matériau laissant passer au moins 90% de l'intensité lumineuse de la lumière présentant cette longueur d'onde d'intérêt.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

Pour déterminer la géométrie du diffuseur et les compositions des différentes couches, on peut procéder à des analyses de microscopie optique ou de Microscopie Electronique à Balayage (MEB).

Les compositions chimiques des différentes couches ou régions peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de structures de petites tailles telles que des nanostructures métalliques. Elle peut être mise en œuvre sur des coupes métallurgiques au sein d'un Microscope Electronique à Balayage (MEB).

Ces techniques permettent notamment de déterminer si le diffuseur comprend une couche de diffusion comprenant au moins une nanostructure métallique, ou une pluralité de structures métalliques, telle que décrite dans la présente invention.

Le diffuseur selon les différents aspects de l'invention est destiné à diffuser une lumière visible émise par une source de lumière, de préférence une source ponctuelle de lumière. Selon les cas, la lumière émise par cette source peut notamment être transmise, focalisée, diffusée, rétrodiffusée, réfléchie, extraite par le diffuseur. Avant de décrire en détail les caractéristiques structurelles et la fabrication de ce diffuseur, certains aspects fonctionnels du diffuseur sont illustrés ci-après au travers de résultats obtenus par simulation pour différents modes de réalisation du diffuseur.

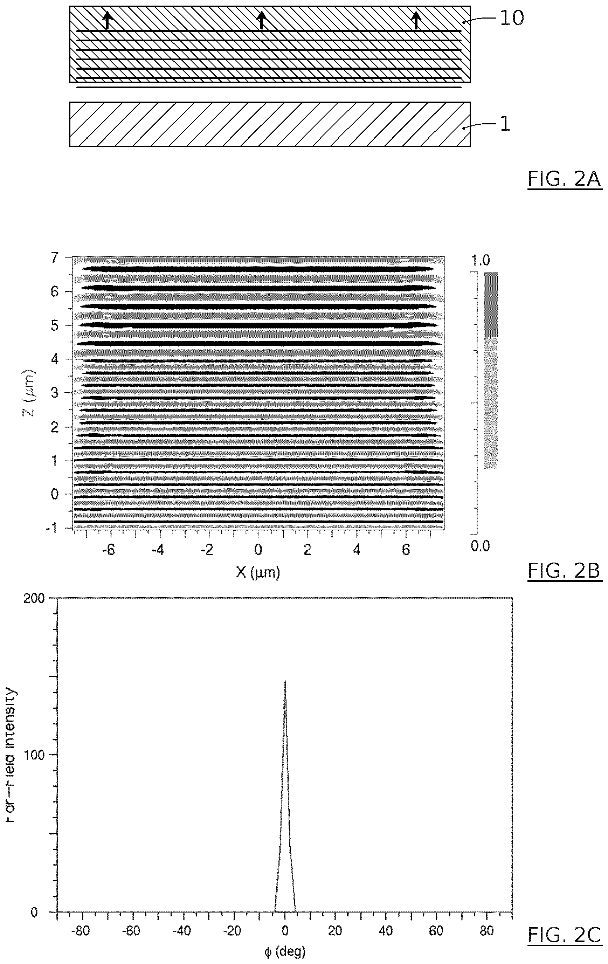

Les figures 2A-2C, 3A-3C et 4A-4C montrent des résultats de simulations réalisées par une méthode de calcul de différences finies dans le domaine temporel (FDTD, acronyme de « Finite Différence Time Domain ») visant à déterminer quelle est la part de lumière transmise (transmission spéculaire à $\Phi$ = 0°) et la part de lumière diffusée (transmission non spéculaire pour $\Phi \neq 0°$) au travers d'un diffuseur recevant une lumière émise par une source 1. Pour chacune des simulations, le diffuseur et la source 1 de lumière sont illustrés en coupe transverse sur les figures xA (x = 2...4). Les cartographies du champ électromagnétique au niveau des diffuseurs sont illustrées sur les figures xB (x = 2...4). Les diagrammes angulaires de ces diffuseurs sont illustrés sur les figures xC (x = 2...4).

Les figures 2A-2C prises comme référence illustrent une transmission de lumière visible (figure 2B) au travers d'un diffuseur comprenant une couche de transmission 10 seule (figure 2A). Le diagramme angulaire montre que la lumière issue de la source 1 est dans ce cas uniquement transmise de façon spéculaire (figure 2C). Le « diffuseur » illustré ici n'est donc pas à proprement parler un dispositif permettant de diffuser la lumière émise par la source. Ce cas est présenté de façon à fournir une première référence qui peut être utilisée pour comparer les performances de diffusion des différents modes de réalisation de diffuseurs présentés dans la suite.

Les figures 3A-3C illustrent une transmission de lumière visible (figure 3B) au travers d'un diffuseur comprenant une couche de transmission 10 et une couche de diffusion 21 à base de nanostructures diélectriques désordonnées (figure 3A). Le diagramme angulaire montre que la lumière émise par la source 1 est dans ce cas majoritairement transmise de façon spéculaire. La part de lumière diffusée est faible (figure 3C).

Un tel diffuseur est donc une solution permettant de diffuser la lumière émise par une source de lumière ponctuelle. Cette solution ne permet cependant pas de diffuser efficacement la lumière et n'est pas l'objet de la présente invention.

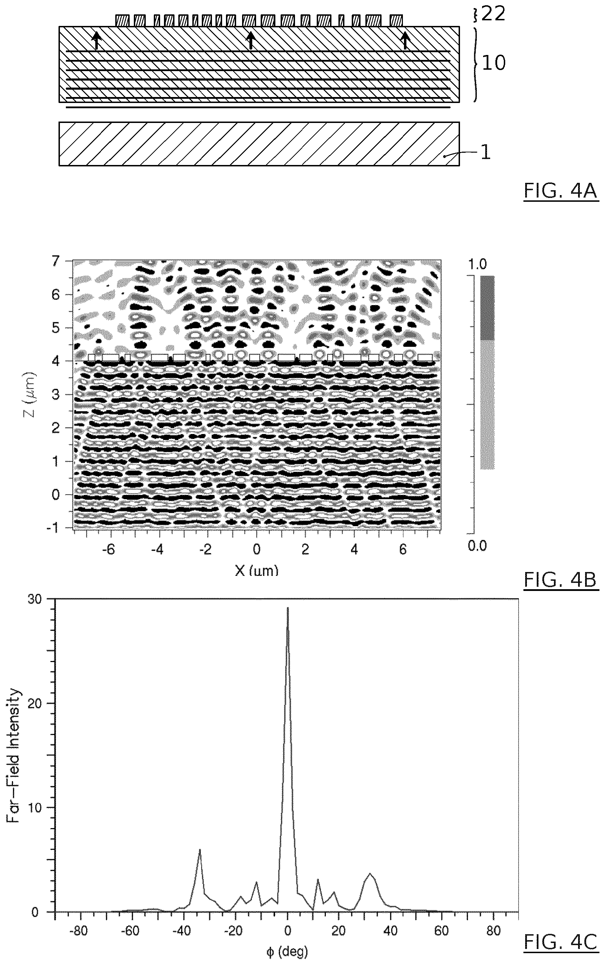

Les figures 4A-4C illustrent une transmission de lumière visible (figure 4B) au travers d'un diffuseur selon l'invention, comprenant une couche de transmission 10 et une couche de diffusion 22 à base de nanostructures métalliques désordonnées (figure 4A). Le diagramme angulaire montre que la part de lumière diffusée est dans ce cas largement augmentée par rapport au diffuseur précédent (figure 4C).

Les nanostructures métalliques permettent une diffusion de la lumière visible significativement plus efficace que des nanostructures diélectriques. Ceci est notamment dû au contraste d'indices de réfraction entre les nanostructures métalliques et la couche de transmission généralement à base d'un matériau diélectrique transparent.

De façon préférée mais optionnelle, ce diffuseur comprend en outre une couche de focalisation configurée pour focaliser la lumière émise sur une nanostructure métallique de la pluralité de nanostructures métalliques. Cela permet d'augmenter la part de lumière diffusée par le diffuseur. La lumière émise par la source, en particulier une source ponctuelle, est ainsi focalisée au niveau d'une nanostructure, de préférence une seule nanostructure. La focalisation permet d'induire une divergence de la lumière au-delà de la nanostructure. Cette divergence augmente la part de lumière transmise de façon non spéculaire.

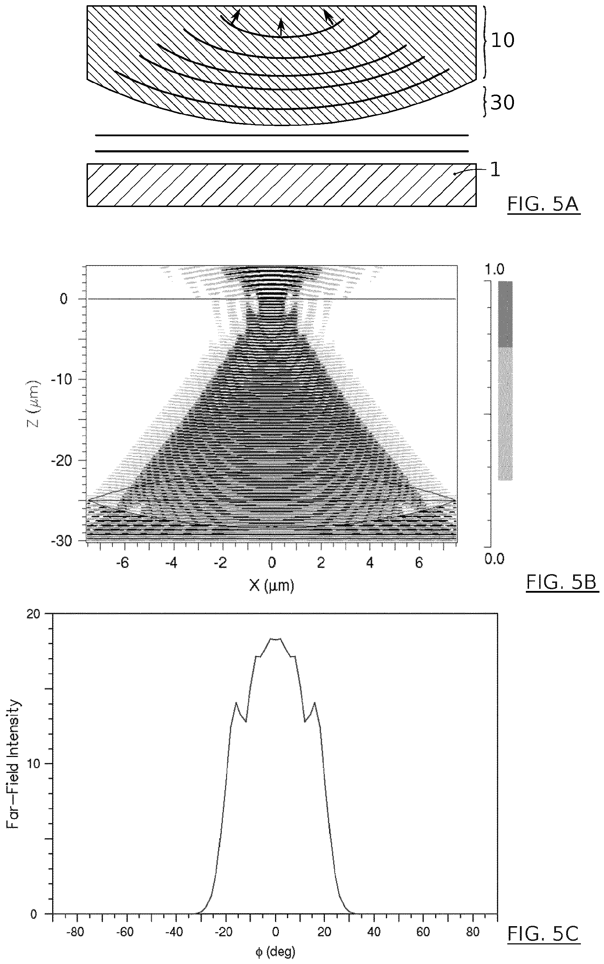

Les figures 5A-5C, 6A-6C, 7A-7C et 8A-8C montrent d'autres résultats de simulations réalisées par FDTD, pour différents modes de réalisation de diffuseurs comprenant une couche de focalisation. Pour chacune des simulations, le diffuseur et la source 1 de lumière sont illustrés en coupe transverse sur les figures xA (x = 5...8). Les cartographies du champ électromagnétique au niveau des diffuseurs sont illustrées sur les figures xB (x = 5...8). Les diagrammes angulaires de ces diffuseurs sont illustrés sur les figures xC (x = 5... 8).

Les figures 5A-5C illustrent une transmission de lumière (figure 5B) au travers d'un diffuseur comprenant une couche de transmission 10 et une couche de focalisation 30 (figure 5A). Le diagramme angulaire (figure 5C) montre que la part de lumière transmise de façon non spéculaire est dans ce cas largement augmentée par rapport au cas de référence illustré aux figures 2A-2C. Le « diffuseur » illustré ici n'est cependant pas à proprement parler un dispositif permettant de diffuser la lumière émise par la source 1. Ce cas est présenté de façon à fournir une deuxième référence qui peut être utilisée pour comparer les performances de diffusion des différents modes de réalisation de diffuseurs comprenant une couche de focalisation, tels que présentés dans la suite.

Dans le cas d'un diffuseur comprenant une couche de diffusion à base d'une ou d'une pluralité de nanostructures métalliques, la focalisation de la lumière sur quelques nanostructures seulement, voire sur une seule nanostructure, permet d'éviter tout effet de réseau, et favorise donc une diffusion isotrope de la lumière.

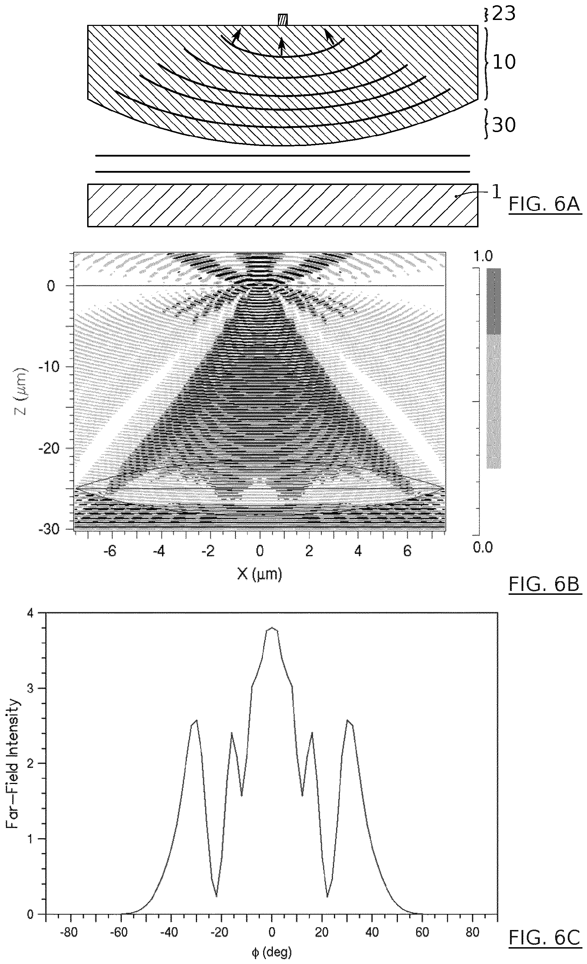

Selon une possibilité illustrée à la figure 6A, la couche de diffusion 23 de ce diffuseur peut être à base d'une ou d'au moins une nanostructure métallique.

Les figures 6A-6C illustrent une transmission de lumière (figure 6B) au travers d'un tel diffuseur comprenant une couche de transmission 10, une couche de focalisation 30 et une couche de diffusion 23 à base d'une nanostructure métallique (figure 6A). Le diagramme angulaire (figure 6C) montre que la part de lumière diffusée est augmentée par rapport au cas illustré aux figures 4A-4C. Ce diagramme est en outre symétrique, ce qui traduit le caractère isotrope d'une telle diffusion.

Selon une possibilité, la couche de diffusion de ce diffuseur peut être à base d'une pluralité de nanostructures métalliques. Dans ce cas, seules quelques nanostructures métalliques sont effectivement illuminées après focalisation de la lumière. Les effets de réseau sont dans ce cas fortement limités, voire supprimés.

De façon préférée mais optionnelle, le diffuseur comprend en outre une couche de réflexion située entre la couche de diffusion et la couche de focalisation au sein de la couche de transmission, parallèle à la couche de diffusion et présentant au moins une ouverture en regard de la nanostructure métallique sur laquelle la lumière émise est focalisée. Cela permet d'augmenter la transmission totale du diffuseur.

La transmission totale du diffuseur correspond à la partie de la lumière que peut percevoir un observateur regardant la source de lumière au travers du diffuseur.

La diffusion par la ou les nanostructures métalliques se fait selon une multitude de directions, en partie dans le même sens que la lumière émise (c'est la lumière transmise et diffusée que peut percevoir l'observateur) et en partie dans un sens opposé à celui de la lumière émise (c'est la lumière rétrodiffusée que ne peut pas percevoir l'observateur).

La couche de réflexion permet avantageusement de réfléchir une partie de la lumière rétrodiffusée en direction de l'observateur. La transmission totale du diffuseur est donc améliorée.

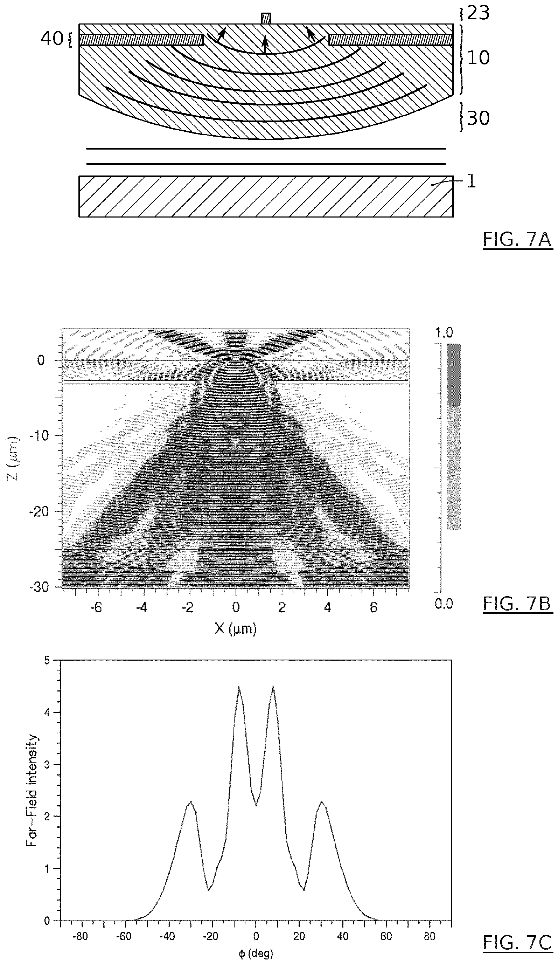

Selon une possibilité illustrée à la figure 7A, la couche de diffusion 23 de ce diffuseur comprenant une couche de réflexion 40 peut être à base d'une ou d'au moins une nanostructure métallique.

Les figures 7A-7C illustrent une transmission de lumière (figure 7B) au travers d'un tel diffuseur comprenant une couche de transmission 10, une couche de focalisation 30, une couche de réflexion 40 et une couche de diffusion 23 à base d'une nanostructure métallique (figure 7A). Le diagramme angulaire montre que la transmission totale, proportionnelle à l'intégrale de la fonction définissant la courbe de la figure 7C, est augmentée par rapport au cas précédent illustré aux figures 6A-6C. La transmission totale du diffuseur, de l'ordre de 50% de la lumière émise dans le cas précédent, peut ainsi être augmentée jusqu'à environ 70% de la lumière émise.

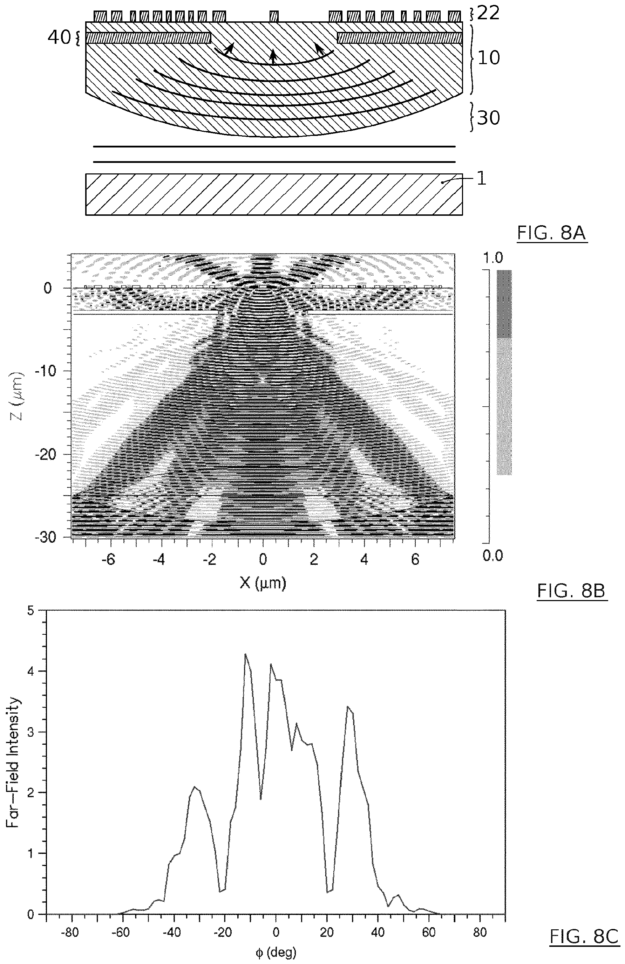

Selon une possibilité illustrée à la figure 8A, la couche de diffusion 22 de ce diffuseur comprenant une couche de réflexion 40 peut être à base d'une pluralité de nanostructures métalliques. Cela permet avantageusement de favoriser l'extraction d'une partie dite rasante de la lumière rétrodiffusée par la nanostructure métallique au point de focalisation.

La partie rasante de la lumière rétrodiffusée comprend des rayons lumineux dont la direction de propagation forme un angle avec la couche de diffusion inférieur à l'angle de réflexion totale interne de la couche de transmission. Ces rayons sont donc piégés au sein de la couche de transmission entre la couche de diffusion et la couche de réflexion, en l'absence de singularités au niveau de l'une et/ou de l'autre de ces interfaces. La présence d'une pluralité de nanostructures métalliques dans la couche de diffusion permet de générer des singularités favorisant l'extraction de ces rayons lumineux de la couche de transmission en direction de l'observateur. La transmission totale est donc augmentée.

Les figures 8A-8C illustrent une transmission de lumière (figure 8B) au travers d'un diffuseur comprenant une couche de transmission 10, une couche de focalisation 30, une couche de réflexion 40 et une couche de diffusion 22 à base d'une pluralité de nanostructures métalliques (figure 8A). La transmission totale de ce diffuseur, déductible du diagramme angulaire (figure 8C), est augmentée d'environ 5% par rapport au cas précédent illustré aux figures 7A-7C.

Par ailleurs, le diagramme angulaire d'un tel diffuseur est élargi. La diffusion de la lumière est optimisée.

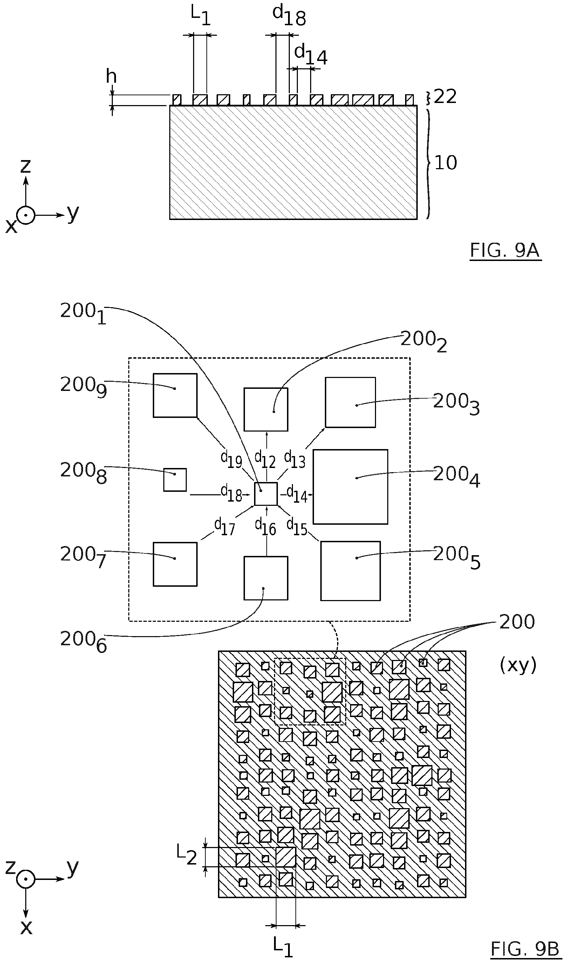

Un premier mode de réalisation d'un diffuseur selon l'invention va maintenant être décrit en référence aux figures 9A, 9B.

Selon ce premier mode de réalisation, le diffuseur comprend une couche de transmission 10 en un matériau transparent dans au moins une partie de la gamme de longueur d'onde du visible, en particulier aux longueurs d'onde de la lumière à transmettre.

Ce matériau transparent peut être à base d'oxyde de silicium, de nitrure de silicium, de saphir.

La couche de transmission 10 forme notamment un support transparent pour la couche de diffusion 22 du diffuseur.

Cette couche de diffusion 22 comprend une pluralité de nanostructures métalliques 200 encore désignées structures métalliques 200 ou particules 200. Ces nanostructures métalliques 200 sont distinctes les unes des autres et peuvent s'apparenter à des particules métalliques. Elles sont situées à distance les unes des autres. Ainsi deux nanostructures métalliques 200 sont séparées par un matériau différent du matériau métallique constituant les nanostructures métalliques 200. Typiquement, deux nanostructures métalliques 200 sont séparées par le matériau formant la couche de transmission 10.

Les nanostructures métalliques 200 peuvent présenter une hauteur h comprise entre 100 nm et 500 nm (figure 9A).

Ces nanostructures 200 présentent des première et deuxième dimensions L1, L2 en projection dans le plan d'extension principal xy inférieures à 650 nm. Ces dimensions, dites dimensions d'extension principales, sont en particulier inférieures aux longueurs d'onde d'intérêt de la lumière à diffuser.

Les nanostructures 200 peuvent présenter des dimensions d'extension principales L1, L2 comprises entre 100 nm et 500 nm, de préférence entre 100 nm et 400 nm. Ces dimensions L1, L2 sont portées par deux directions du plan xy orthogonales entre elles, par exemple les directions x et y. Cela permet de favoriser une diffusion isotrope de la lumière.

Sur l'exemple illustré en figure 9B, pour toutes les nanostructures métalliques 200, les premières dimensions L1 s'étendent toutes selon des premières directions parallèles à l'axe x du repère xyz et les deuxièmes directions L2 s'étendent toutes selon des deuxièmes directions parallèles à l'axe y du repère xyz. Cet exemple n'est pas limitatif et selon une autre possibilité, les premières directions selon lesquelles s'étendent les premières dimensions L1 ne sont pas toutes parallèles entre elles, et, corolairement, les deuxièmes directions - orthogonales aux premières directions - selon lesquelles s'étendent les deuxièmes dimensions L2 ne sont pas toutes parallèles entre elles.

Les dimensions d'extension principales peuvent être telles que L1 = L2. Cela permet également de favoriser une diffusion isotrope de la lumière.

Les nanostructures peuvent présenter différentes formes en projection dans le plan d'extension principal xy, par exemple des formes carrées telles que représentées à la figure 9B, ou rondes, ou présentant un degré de symétrie permettant de privilégier une diffusion isotrope. Les nanostructures 200 présentent de préférence un axe de symétrie d'ordre n normal au plan d'extension principal xy, avec n ≥ 3. Elles présentent dès lors une invariance par rotation d'un angle $2\pi/n$.

Elles présentent de préférence des tailles variées. Les tailles des nanostructures 200, par exemple leurs dimensions critiques ou leurs surfaces en projection dans le plan xy, présentent de préférence une variation significative, par exemple de l'ordre de 200%, voire 300%, voire 500%, entre la plus petite nanostructure 200 et la plus grande nanostructure 200 de la couche de diffusion 22. Un facteur 2, voire 3, voire 5 entre les plus petites et les plus grandes nanostructures permet d'obtenir une gamme de tailles relativement large.

La variation des surfaces des nanostructures métalliques peut ainsi être telle que $S_{max} \geq x*S_{min}$, avec $S_{max}$ et $S_{min}$ respectivement les surfaces maximale et minimale au sein de la couche de diffusion, et x = 2, de préférence x = 3 et de préférence x = 5.

La variation des dimensions critiques des nanostructures métalliques peut ainsi être telle que $T_{max} \geq x*T_{min}$, avec $T_{max}$ et $T_{min}$ respectivement les dimensions critiques maximale et minimale au sein de la couche de diffusion, et x = 2, de préférence x = 3 et de préférence x = 5.

La variation des dimensions des nanostructures métalliques 200 peut concerner uniquement la dimension L1 ou peut concerner uniquement la dimension L2 ou concerner à la fois la dimension L1 et la dimension L2.

En outre, la distribution en taille des nanostructures sur cette gamme de tailles est de préférence suffisamment étalée.

Dans le cas d'une distribution en taille des nanostructures étroite ou gaussienne, la formation d'un réseau ordonné de nanostructures est en effet favorisée. Le degré d'ordre élevé de ce réseau ordonné favorise certaines interactions avec l'onde incidente de la lumière émise par la source (par exemple par résonance). C'est ce qui est appelé dans la suite « effet de réseau ». En conséquence, la lumière est extraite via ce réseau ordonné selon certaines directions privilégiées seulement. Dans ce cas, la diffusion n'est pas isotrope.

Au contraire, une distribution en taille des nanostructures étalée favorise la formation d'un réseau désordonné de nanostructures. Le degré d'ordre faible de ce réseau désordonné limite l'effet de réseau. En conséquence, la lumière est extraite via ce réseau désordonné de façon plus isotrope. Le diagramme angulaire de diffusion est amélioré (cas exposé à la figure 4C).

Selon une possibilité avantageuse, la distribution en taille des nanostructures 200, par exemple selon la dimension critique ou selon une dimension moyenne $L1 + L2/2$, est de préférence la plus étalée possible dans la gamme 100 nm à 500 nm ou dans la gamme 100 nm à 400 nm. Par exemple, au sein de la couche de diffusion 22 parmi la pluralité de nanostructures métalliques 200, au moins quelques nanostructures métalliques (par exemple au moins 10, de préférence au moins 20) présentent des dimensions d'extension principales inférieures à 250 nm et au moins quelques nanostructures métalliques (par exemple au moins 10, de préférence au moins 20) présentent des dimensions d'extension principales supérieures à 350 nm.

Les nanostructures métalliques 200 sont de préférence également dispersées ou réparties sur la couche de transmission 10 de façon aléatoire ou désorganisée. Les nanostructures métalliques 200 présentent notamment une pluralité de distances de séparation $d_{ij}$ entre nanostructures adjacentes (figure 9B).

Ces distances de séparation $d_{ij}$, dites également distances interparticulaires, sont de préférence comprises dans la gamme 100 nm à 1000 nm.

Les distances de séparation présentent de préférence une variation significative, par exemple de l'ordre de 200%, voire 300%, voire 500%, entre la plus petite distance et la plus grande distance de séparation entre deux nanostructures adjacentes de la couche de diffusion 22. Un facteur 2, voire 3, voire 5 entre les plus petites et les plus grandes distances de séparation permet d'obtenir une gamme de distances relativement large.

En outre, la distribution des distances interparticulaires sur cette gamme est de préférence suffisamment étalée.

Dans le cas d'une distribution des distances interparticulaires étroite ou gaussienne favorise la formation d'un réseau ordonné de nanostructures présentant un degré d'ordre élevé.

Au contraire, une distribution des distances interparticulaires étalée favorise la formation d'un réseau désordonné de nanostructures présentant un degré d'ordre faible.

Selon une possibilité avantageuse, la distribution des distances interparticulaires des nanostructures 200 est de préférence la plus étalée possible dans la gamme 100 nm à 1000 nm. Cela permet de limiter l'effet de réseau.

Pour obtenir une distribution des distances interparticulaires étalée, au moins certaines des nanostructures métalliques adjacentes peuvent présenter des distances de séparation inférieures à 500 nm, et au moins certaines autres des nanostructures métalliques adjacentes peuvent présenter des distances de séparation supérieures à 600 nm. Selon un exemple illustré à la figure 9B, pour une nanostructure $200_1$ entourée par 8 nanostructures $200_2$, $200_3$, $200_4$, $200_5$, $200_6$, $200_7$, $200_8$, $200_9$ proches voisines, les distances interparticulaires d12, d13, d14, d15, d16, d17, d18, d19 sont de préférence différentes entre elles, et de préférence suffisamment différentes de sorte qu'une partie desdites distances, par exemple d12, d14, d16, soit inférieure à 500 nm, et qu'une autre partie desdites distances, par exemple d13, d17, d18, d19, soit supérieure à 600 nm.

Selon un autre exemple non illustré, les distances interparticulaires entre la nanostructure $200_1$ et chacune des nanostructures $200_2$, $200_3$, $200_4$, $200_5$, $200_6$, $200_7$, $200_8$, $200_9$ adjacentes à cette nanostructure $200_1$ sont toutes différentes entre elles.

La réalisation d'une telle couche de diffusion 22 peut avantageusement se faire par des technologies planaires standard de la microélectronique (dépôt, lithographie, gravure), comme exposé plus loin dans la description.

Elle peut être alternativement réalisée par une simple étape de dépôt de nanoparticules métalliques présentant les caractéristiques de tailles mentionnées ci-dessus. Ce dépôt peut se faire à partir de solutions colloïdales de nanoparticules du commerce, par dépôt gravitaire et/ou par des techniques d'électrodéposition ou d'électrophorèse bien connues.

D'autres modes de réalisation du diffuseur selon l'invention peuvent être envisagés. Seules les caractéristiques distinctes du premier mode de réalisation sont décrites ci-après, les autres caractéristiques non décrites étant réputées identiques à celles du premier mode de réalisation.

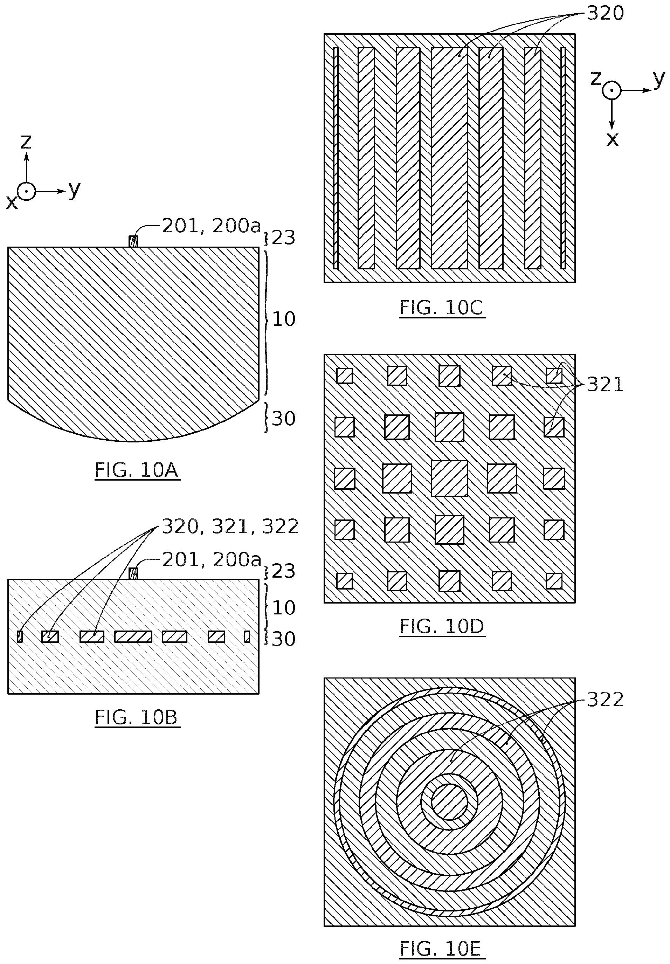

Un deuxième mode de réalisation d'un diffuseur selon l'invention va maintenant être décrit en référence aux figures 10A à 10E.

Selon ce deuxième mode de réalisation, le diffuseur comprend une couche de transmission 10, une couche de diffusion 23 comprenant au moins une nanostructure métallique 201, 200a, et une couche de focalisation 30. La couche de transmission 10 est intercalée entre la couche de diffusion 23 et la couche de focalisation 30.

La couche de diffusion 23 peut comprendre une seule nanostructure métallique 201. Une couche de diffusion 22 comprenant une pluralité de nanostructures métalliques 200 peut alternativement être utilisée.

La couche de focalisation 30 peut présenter une continuité de matière avec la couche de transmission 10. Sur les figures d'accompagnement, les couches de focalisation et de transmission 30, 10 sont matérialisées par des accolades. Cela permet de distinguer au moins fonctionnellement ces différentes couches, même si elles peuvent ne pas être structurellement distinctes.

La couche de focalisation 30 est configurée pour focaliser la lumière émise par la source sur la nanostructure 201, ou sur une nanostructure 200a de la pluralité de nanostructures métalliques 200, ou sur quelques nanostructures 200a de la pluralité de nanostructures métalliques 200, par exemple de 2 à 10.

La lumière émise par la source, par exemple une onde incidente plane arrivant sur la couche de focalisation 30, se propage ainsi jusqu'à la nanostructure 201, 200a dans un cône d'illumination au sommet duquel se trouve la nanostructure 201, 200a.

La couche de focalisation 30 permet donc d'améliorer la diffusion (transmission non spéculaire) du diffuseur. L'association de cette couche de focalisation 30 à une seule nanostructure métallique 201 ou à seulement quelques nanostructures 200a permet en outre d'améliorer le caractère isotrope de la diffusion (cas exposé à la figure 6C).

Selon une possibilité illustrée à la figure 10A, la couche de focalisation 30 se présente sous forme d'une lentille, également désignée microlentille, par exemple réfractive. Cette microlentille 300 forme typiquement un relief d'un côté de la couche de transmission 10 opposé au côté de la couche de transmission 10 supportant la couche de diffusion 23.

La largeur ou le diamètre D d'une telle microlentille, prise parallèlement au plan d'extension principal, correspond à la largeur du diffuseur. Elle est de préférence comprise entre 5 $\mu$m et 30 $\mu$m, par exemple environ 15 $\mu$m.

La distance focale de cette microlentille 300, qui correspond sensiblement à l'épaisseur H' de la couche de transmission 10, est typiquement de l'ordre de quelques microns, par exemple 8 ≤ H' ≤ 12 $\mu$m, à quelques centaines de microns, par exemple H' ≈ 700 $\mu$m pour un substrat verre.

Selon une possibilité illustrée à la figure 10B, la couche de focalisation 30 se présente sous forme d'une lentille de Fresnel 303.

Une telle lentille de Fresnel peut comprendre, dans un plan parallèle au plan d'extension principal, des motifs géométriques 300, 301, 302 en un matériau présentant un indice de réfraction relativement élevé par rapport au matériau transparent environnant. Le principe d'une telle lentille de Fresnel 303 est largement connu.

Différents motifs géométriques 300, 301, 302 peuvent ainsi permettre une focalisation de la lumière sur la ou les nanostructures 201, 200.

Ces motifs peuvent par exemple comprendre :

　　Des bandes parallèles 300 de largeur progressivement décroissante depuis le centre de la lentille (figure 10C),
　　Des carrés 301 ou des disques de largeur ou de diamètre progressivement décroissants depuis le centre la lentille (figure 10D),
　　Des anneaux concentriques 302 de largeur progressivement décroissante depuis le centre la lentille (figure 10E).

Une telle couche de focalisation comprenant une lentille de Fresnel peut avantageusement être réalisée par des technologies planaires standard de la microélectronique (dépôt, lithographie, gravure), comme exposé plus loin dans la description.

L'encombrement total d'un diffuseur comprenant une lentille de Fresnel peut être réduit par rapport à un diffuseur comprenant une microlentille réfractive. En particulier la hauteur de ce diffuseur peut être diminuée.

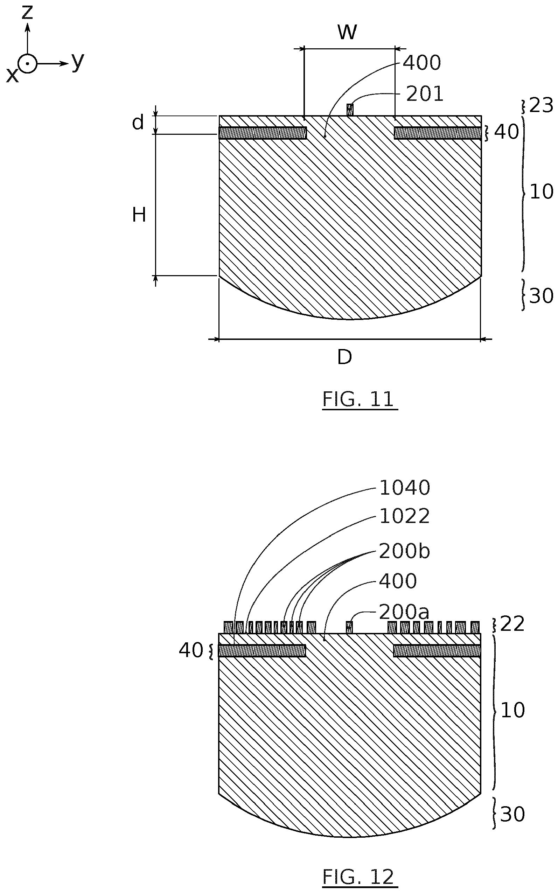

Un troisième mode de réalisation d'un diffuseur selon l'invention va maintenant être décrit en référence aux figures 11 et 12.

Selon ce troisième mode de réalisation, le diffuseur comprend une couche de transmission 10, une couche de diffusion 23 comprenant au moins une nanostructure métallique 201 ou une couche de diffusion 22 comprenant une pluralité de nanostructures métalliques 200a, 200b, une couche de focalisation 30, et une couche de réflexion 40. Comme dans l'exemple précédent, la couche de focalisation 30 peut être formée par une microlentille en continuité de la couche transmission 10.

La couche de réflexion 40 est intercalée entre la couche de diffusion 22, 23 et la couche de focalisation 30. Elle peut être disposée au sein de la couche de transmission 10, à une distance d de la couche de diffusion 22, 23, et à une distance H de la couche de focalisation 30.

La couche de réflexion 40 est configurée pour réfléchir une partie de la lumière rétrodiffusée par la ou les nanostructures métalliques 201, 200a sur lesquelles la lumière émise est focalisée. La lumière rétrodiffusée présente en effet un sens de propagation opposé à celui de la lumière diffusée en direction d'un observateur. La couche de réflexion 40 permet de réfléchir une partie de cette lumière rétrodiffusée en direction de l'observateur.

Cette couche de réflexion 40 permet ainsi d'améliorer la transmission totale du diffuseur.

La couche de réflexion 40 présente une ouverture 400 approximativement centrée sur la nanostructure métallique 201, 200a de la couche de diffusion 23, 22. Cette ouverture 400 présente une dimension en largeur ou un diamètre d'ouverture W. Ce diamètre d'ouverture W vérifie de préférence la relation :

$$W = \frac{D.d}{H + d}$$

où D est le diamètre de la lentille de focalisation 300, 303, d est la distance séparant la couche de diffusion 22, 23 de la couche de réflexion 40 (d peut être pris entre les faces en regard des couches concernées, ou entre les centres des couches concernées), H est la distance séparant la couche de réflexion 40 de la couche de focalisation 30 (figure 11).

En pratique, une valeur typique de H peut être 700 $\mu$m pour un substrat en verre, une valeur typique de D peut être 15 $\mu$m pour la lentille.

Pour une onde incidente non plane, par exemple pour une lumière émise par une LED présentant une faible divergence et formant un cône d'émission, il est avantageux de diminuer la valeur de H. Cela permet de limiter une perte de transmission pour des rayons lumineux présentant des angles d'incidence proches des bords du cône d'émission de la LED.

Il est également particulièrement avantageux de maximiser la valeur de d afin de maximiser le diamètre W d'ouverture 400. Cela permet d'augmenter une ouverture angulaire pour la lumière rétrodiffusée.

En pratique, une valeur typique de d atteignable par des technologies planaires standard de la microélectronique est comprise entre 1 μm et 20 μm.

Pour une valeur de d donnée, par exemple d = 3 μm, ou d = 7 μm, la relation ci-dessus permet d'optimiser le dimensionnement de l'ouverture W.

Si $W < \frac{D.d}{H+d}$ une partie de la lumière émise par la source ne parvient pas jusqu'à la nanostructure 201, 200a.

Si $W > \frac{D.d}{H+d}$ une partie de la lumière rétrodiffusée par la nanostructure 201, 200a en dehors du cône d'illumination n'est pas réfléchie.

Selon une possibilité illustrée à la figure 11, la couche de diffusion 23 peut comprendre une seule nanostructure métallique 201.

Les rayons lumineux rétrodiffusés par la nanostructure 201 puis réfléchis par la couche de réflexion 40 en direction de l'observateur permettent de renforcer la diffusion non spéculaire du diffuseur.

La diffusion angulaire du diffuseur est par ailleurs parfaitement isotrope (cas exposé à la figure 7C).

Selon une autre possibilité illustrée à la figure 12, la couche de diffusion 22 peut comprendre une pluralité de nanostructures métalliques 200a, 200b.

Dans ce dernier cas, seules une ou quelques nanostructures 200a sont illuminées directement par le cône d'illumination formé par la couche de focalisation 30.

Les nanostructures métalliques 200b permettent avantageusement de favoriser l'extraction, en direction de l'observateur, d'une partie dite rasante de la lumière rétrodiffusée par la ou les nanostructures métalliques 200a au point de focalisation.

Cette partie rasante comprend en particulier les rayons lumineux dont la direction de propagation forme un angle avec la couche de diffusion 22 inférieur à l'angle de réflexion totale au niveau de l'interface 1022 entre la couche de transmission 10 et la couche de diffusion 22. Lors de leur propagation, ces rayons lumineux rasants sont successivement réfléchis à l'interface 1022, puis à l'interface 1040 entre la couche de transmission 10 et la couche de réflexion 40. Ces rayons lumineux rasants sont donc piégés au sein de la couche de transmission 10 et ne sont pas transmis en direction de l'observateur.

De façon avantageuse, les nanostructures métalliques 200b forment des singularités à l'interface 1022. Ces singularités favorisent l'extraction des rayons lumineux rasants, depuis la couche de transmission 10 en direction de l'observateur. La transmission totale du diffuseur est augmentée.

Les rayons lumineux rasants ainsi diffusés par les nanostructures 200b présentent des angles de diffusion relativement plus élevés que les rayons lumineux directement diffusés par la nanostructure 200a.

La diffusion angulaire du diffuseur est ainsi élargie (cas exposé à la figure 8C).

Dans la suite, le diffuseur illustré aux figures 7A et 11 est évalué pour des conditions de réalisation ou de fonctionnement non optimales.

L'efficacité de diffusion est en particulier évaluée :

- pour différentes longueurs d'onde de la lumière incidente, émise par la source 1 (cas « longueurs d'onde »), puis

- pour un diffuseur dont l'ouverture 400 est décentrée vis-à-vis de la nanostructure 201 (cas « désalignement »), puis

- pour un diffuseur dont le cône d'illumination n'est pas normal aux couches de réflexion et de diffusion 40, 23 (cas « angle d'incidence »).

Longueurs d'onde

Le diffuseur évalué ci-dessous par le biais des simulations FDTD comprend une couche de transmission 10, une couche de focalisation 30, une couche de réflexion 40 et une couche de diffusion 23 à base d'une nanostructure métallique 201.

Le diamètre D de la lentille de focalisation est ici égal à 15 μm. La distance d séparant la couche de diffusion 23 de la couche de réflexion 40 est ici égale à 3 μm. La distance H séparant la couche de réflexion 40 de la couche de focalisation 30 est ici égale à 12 μm. Le diamètre de l'ouverture 400 dans la couche de réflexion 40 est ici égal à 1,36 μm.

La lumière émise par la source 1 est une onde incidente plane.

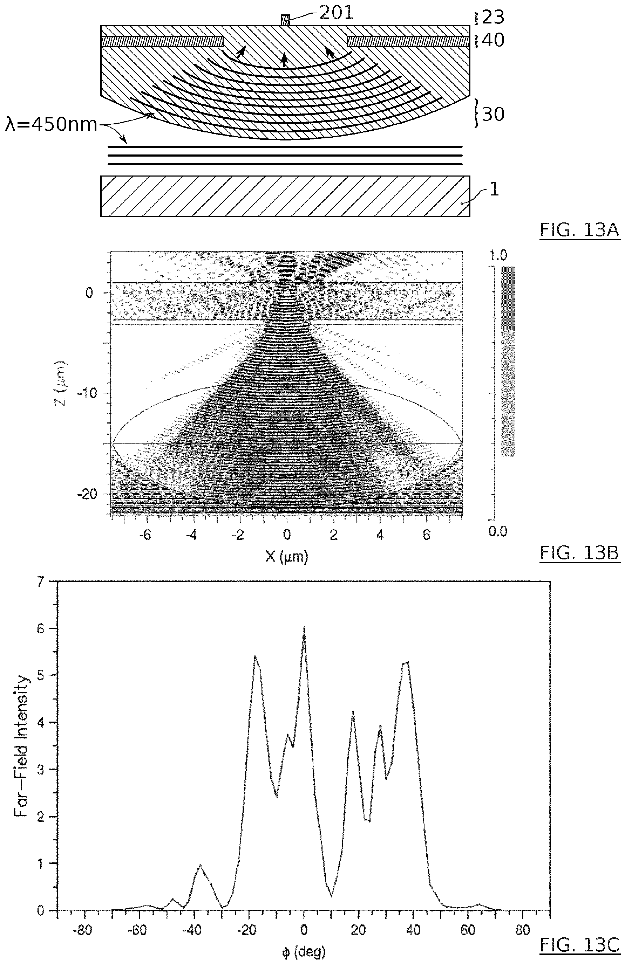

Les figures 13A et 13B illustrent une transmission de lumière de longueur d'onde λ = 450 nm (figure 13B) au travers d'un tel diffuseur (figure 13A).

Le diagramme angulaire obtenu dans ces conditions de réalisation et d'illumination est montré à la figure 13C.

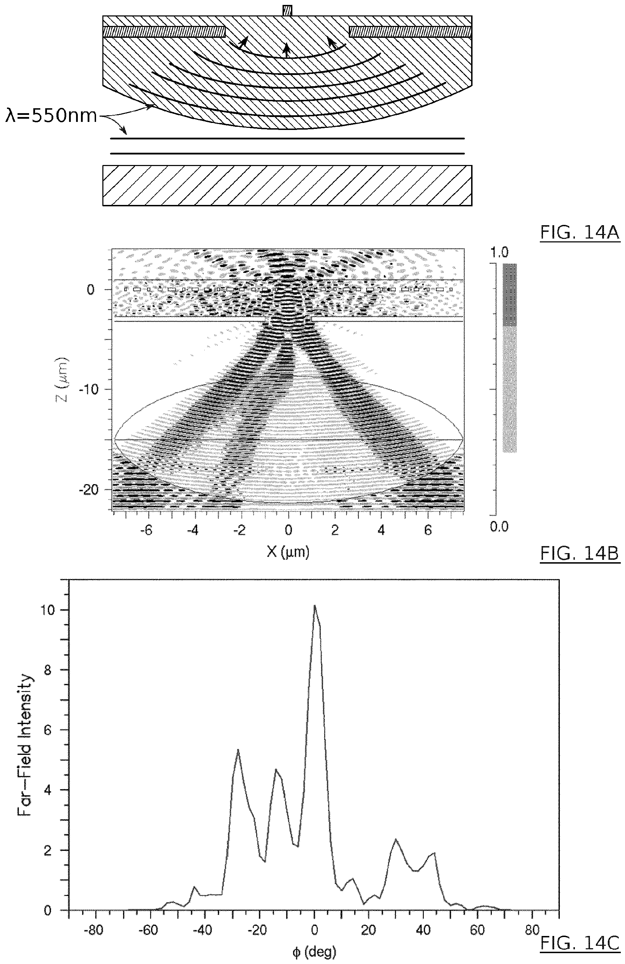

Les figures 14A et 14B illustrent une transmission de lumière de longueur d'onde λ = 550 nm (figure 14B) au travers d'un tel diffuseur (figure 14A). Le diagramme angulaire obtenu dans ces conditions de réalisation et d'illumination est montré à la figure 14C.

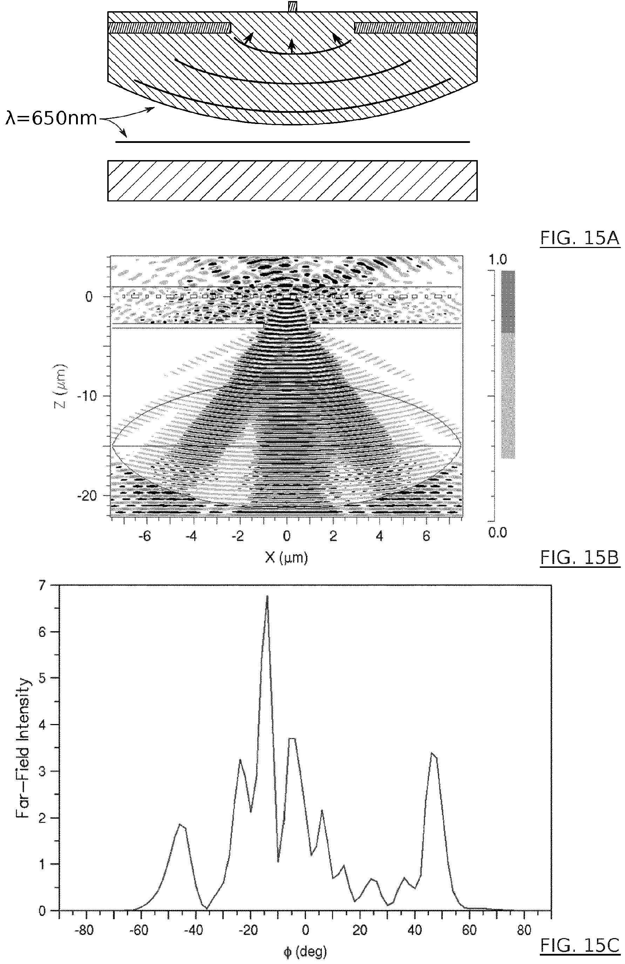

Les figures 15A et 15B illustrent une transmission de lumière de longueur d'onde λ = 650 nm (figure 15B) au travers d'un tel diffuseur (figure 15A). Le diagramme angulaire obtenu dans ces conditions de réalisation et d'illumination est montré à la figure 15C.

En comparant les diagrammes angulaires de diffusion des figures 13C, 14C et 15C, il apparaît que le niveau de transmission du diffuseur (intensité de diffusion en champ lointain « far-field intensity ») est environ constant quelle que soit la longueur d'onde.

La largeur des diagrammes angulaires de diffusion est également relativement large et constante quelle que soit la longueur d'onde.

La variation de longueur d'onde de la lumière émise par la source a donc une influence négligeable sur l'efficacité de diffusion du diffuseur, au moins sur le spectre visible 450 nm à 650 nm.

Cela permet d'envisager une utilisation de ce diffuseur pour des pixels de couleurs différentes d'un écran d'affichage.

L'observateur peut ainsi observer un tel écran d'affichage dans une large gamme d'angles d'observation vis-à-vis de la direction normale à l'écran, sans percevoir de fluctuations d'intensité parasites.

Désalignement

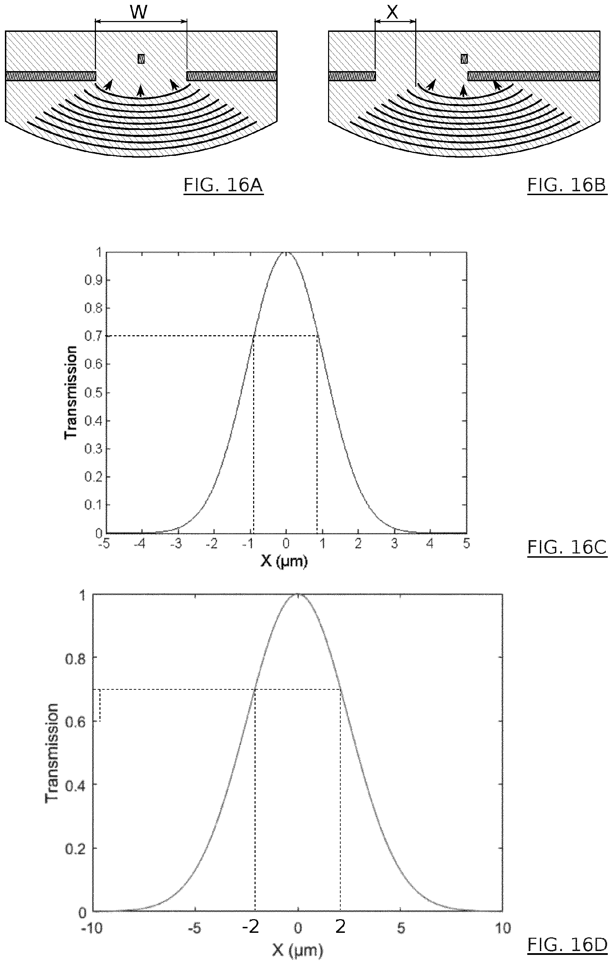

Le diffuseur évalué dans cette section présente un désalignement X entre la nanostructure 201 et le centre de l'ouverture 400, parallèlement à la couche de diffusion. Ce désalignement X est illustré aux figures 16A (nanostructure alignée avec l'ouverture, prise comme référence) et 16B (nanostructure désalignée avec l'ouverture).

Ce désalignement X peut être dû par exemple à une étape technologique de fabrication mal maîtrisée. L'ouverture 400 présente un diamètre W.

Dans un tel cas, la transmission T de la lumière par le diffuseur est donnée par la relation :

$$T = e^{-\frac{4X^2}{W^2}} = e^{-\frac{4X^2(H+d)^2}{D^2d^2}}$$

La figure 16C montre un diagramme de transmission T en fonction du désalignement X, pour les paramètres suivants :

Le diamètre D de la lentille de focalisation est ici égal à 15 μm. La distance d séparant la couche de diffusion 23 de la couche de réflexion 40 est ici égale à 3 μm. La distance H séparant la couche de réflexion 40 de la couche de focalisation 30 est ici égale à 12 μm. Le diamètre de l'ouverture 400 dans la couche de réflexion 40 est ici égal à 1,36 μm.

Dans ces conditions, un désalignement X inférieur à environ ± 1 μm permet de conserver plus de 70% de la lumière transmise par le diffuseur.

Une telle tolérance de l'ordre de ± 1 μm est largement supérieure à la précision de positionnement des différentes couches ou niveaux relativement les uns aux autres dans les technologies standard de la microélectronique.

La figure 16D montre un diagramme de transmission T en fonction du désalignement X, pour les paramètres suivants :

Le diamètre D de la lentille de focalisation est ici égal à 15 μm. La distance d séparant la couche de diffusion 23 de la couche de réflexion 40 est ici égale à 7 μm. La distance H séparant la couche de réflexion 40 de la couche de focalisation 30 est ici égale à 8 μm. Le diamètre de l'ouverture 400 dans la couche de réflexion 40 est ici égal à 7 μm.

Dans ces conditions, un désalignement X inférieur à environ ± 2 μm permet de conserver plus de 70% de la lumière transmise par le diffuseur.

Une telle tolérance de l'ordre de ± 2 μm est largement supérieure à la précision de positionnement des différentes couches ou niveaux relativement les uns aux autres dans les technologies standard de la microélectronique.

Ces conditions de réalisation sont encore plus favorables à la robustesse du diffuseur vis-à-vis d'un défaut d'alignement.

Angle d'incidence

Le diffuseur évalué dans cette section est illuminé par un cône d'illumination présentant un angle d'incidence β par rapport à une direction normale à la couche de réflexion 40 du diffuseur.

Le centre du cône d'illumination, à l'intersection avec l'ouverture 400, est décalé d'une distance X vis-à-vis du centre de l'ouverture 400 aligné avec la nanostructure 201.

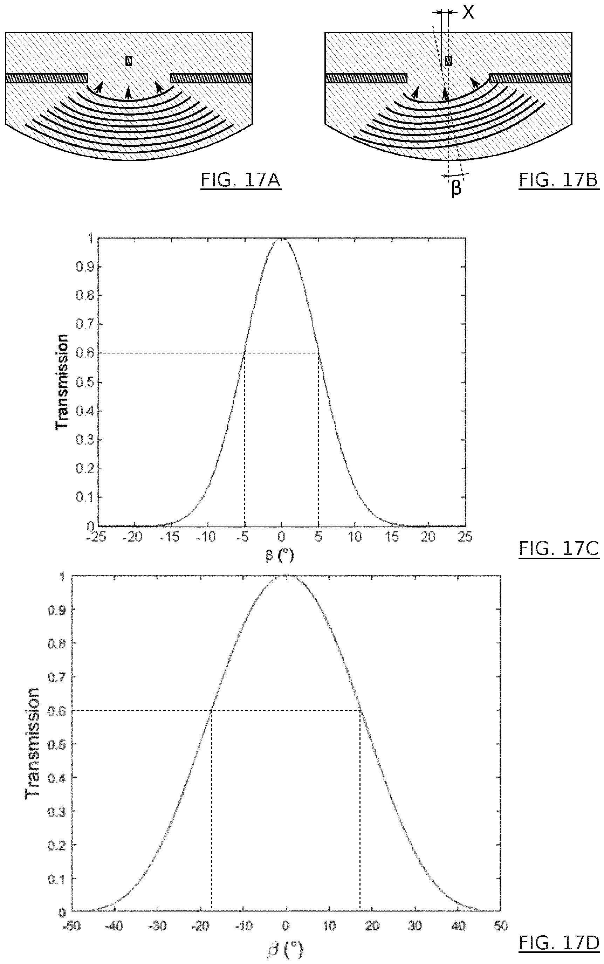

Cette situation d'illumination est illustrée aux figures 17A (angle d'incidence normal, pris comme référence) et 17B (angle d'incidence β).

Cet angle d'incidence β peut être dû par exemple à la divergence du cône d'émission de la source 1, ou à un agencement du diffuseur vis-à-vis de la source mal maîtrisé. L'ouverture 400 présente un diamètre W.

Dans un tel cas, la transmission T de la lumière par le diffuseur est donnée par la relation :

$$T = e^{-\frac{4X^2}{W^2}} = e^{-\frac{4H^2(H+d)^2}{D^2d^2}tan^2\beta}$$

La figure 17C montre un diagramme de transmission T en fonction de l'angle d'incidence β, pour les paramètres suivants :

Le diamètre D de la lentille de focalisation est ici égal à 15 μm. La distance d séparant la couche de diffusion 23 de la couche de réflexion 40 est ici égale à 3 μm. La distance H séparant la couche de réflexion 40 de la couche de focalisation 30 est ici égale à 12 μm. Le diamètre de l'ouverture 400 dans la couche de réflexion 40 est ici égal à 1,36 μm.

Dans ces conditions, un angle d'incidence β inférieur à environ ± 5° permet de conserver plus de 60% de la lumière transmise par le diffuseur.

Une telle tolérance de l'ordre de ± 5° est largement supérieure à la précision d'assemblage dans les technologies standard de la microélectronique.

La figure 17D montre un diagramme de transmission T en fonction l'angle d'incidence β, pour les paramètres suivants :

Le diamètre D de la lentille de focalisation est ici égal à 15 μm. La distance d séparant la couche de diffusion 23 de la couche de réflexion 40 est ici égale à 7 μm. La

distance H séparant la couche de réflexion 40 de la couche de focalisation 30 est ici égale à 8 μm. Le diamètre de l'ouverture 400 dans la couche de réflexion 40 est ici égal à 7 μm.

Dans ces conditions, un angle d'incidence β inférieur à environ ± 20° permet de conserver plus de 60% de la lumière transmise par le diffuseur.

La sensibilité du diffuseur à l'angle d'incidence du cône d'émission est ici réduite par rapport au cas précédent illustré par la figure 17C.

Ces conditions de réalisation sont encore plus favorables à l'efficacité du diffuseur vis-à-vis des conditions d'éclairement.

Une LED GaN standard émet de la lumière dans un cône d'émission présentant un angle maximal de ± 25°. Par ailleurs, l'émission de la LED dans cette gamme angulaire est lambertienne et favorise les angles d'incidence normaux.

Un diffuseur présentant de tels paramètres, en particulier avec H proche de d, est donc parfaitement adapté pour la diffusion de la lumière émise par une LED GaN standard.

Exemples de procédés de réalisation

La présente invention concerne également un procédé de fabrication d'un diffuseur tel que décrit au travers des exemples de réalisation précédents.

Avantageusement, les moyens de fabrication standards de la microélectronique peuvent être mis en œuvre.

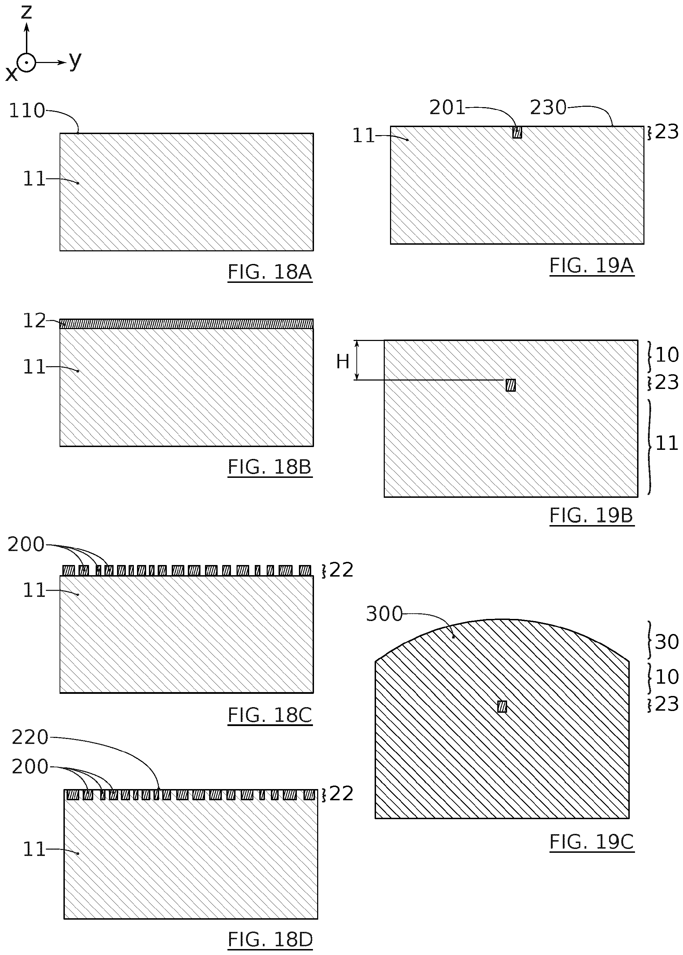

Sur une face 110 d'un substrat 11 transparent dans au moins une partie de la gamme du visible et de préférence dans toute la gamme du visible (figure 18A), par exemple en verre, une couche de métal 12 est déposée (figure 18B).

La couche de métal 12 présente de préférence une épaisseur de l'ordre de 100 nm à 500 nm.

Cette couche de métal 12 peut être en Aluminium. Une telle couche est avantageusement compatible avec les technologies CMOS.

La couche d'aluminium est ensuite structurée de façon connue par lithographie (UV ou faisceau d'électrons) et gravure (RIE par exemple).

Cela permet de former des nanostructures 200 de tailles variées, réparties de façon désorganisée sur le substrat 11 (figure 18C). La couche de diffusion 22 du diffuseur est ainsi formée, de façon simple et en un minimum d'étapes technologiques.

En outre, l'aluminium présente de faibles pertes par absorption. La transmission totale d'un diffuseur à base de nanostructures en aluminium est optimisée.

De façon optionnelle, une étape de planarisation peut également être réalisée.

Une couche transparente, par exemple en silice, peut être déposée autour des nanostructures 200, en particulier entre les nanostructures 200, de sorte à les encapsuler (figure 18D). Une telle couche de diffusion 22 composite présente une tenue mécanique améliorée.

Un polissage, par exemple par CMP (Chemical Mechanical Polishing) peut également être réalisé, notamment de façon à exposer le sommet des nanostructures 200 de la couche de diffusion 22 composite. Cela permet d'obtenir une couche de diffusion 22 composite présentant une face planarisée 220 ayant un état de surface compatible avec d'éventuelles étapes technologiques ultérieures.

Les figures 19A-19C illustrent la réalisation d'un diffuseur comprenant une nanostructure métallique 201 et une microlentille réfractive 300.

Une couche de diffusion 23 comprenant une seule nanostructure métallique 201 est réalisée par lithographie/gravure et planarisée, comme précédemment (figure 19A).

Une couche de transmission 10 en silice est déposée sur la face planarisée 230 de la couche de diffusion 23, sur une épaisseur H' (figure 19B).

Une microlentille 300 en silice est ensuite formée sur la couche de transmission 10 (figure 19C).

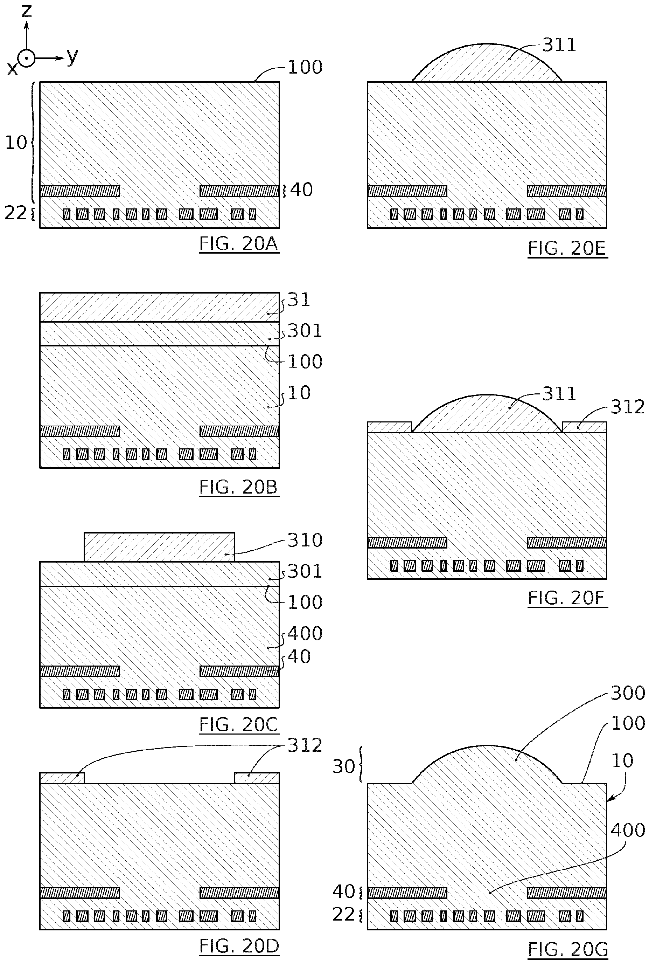

Les figures 20A à 20G illustrent plus particulièrement des exemples de formation d'une telle microlentille 300.

Ces exemples se rapportent à un mode de réalisation du diffuseur comprenant une couche de diffusion 22 à base d'une pluralité de nanostructures, une couche de transmission 10, une couche de réflexion 40, et une couche de focalisation 30 comprenant une microlentille 300. Ces exemples de formation d'une microlentille 300 peuvent néanmoins être adaptés *mutatis mutandis* à d'autres modes de réalisation du diffuseur, en particulier à un diffuseur comprenant une couche de diffusion 23 à base d'une seule nanostructure et/ou à un diffuseur sans couche de réflexion 40.

Afin de réaliser une microlentille 300 en silice sur la face 100 de la couche de transmission 10 (figure 20A), une couche de silice 301 d'épaisseur correspondant à la hauteur de la microlentille peut être préalablement déposée sur cette face 100. La couche de focalisation est ensuite formée à partir de cette couche de silice 301.

Selon un exemple, une couche de résine photosensible 31 d'épaisseur environ égale à la hauteur de la microlentille à réaliser est ensuite déposée sur la couche de silice 301 (figure 20B). Cette résine photosensible 31 est destinée à former un motif de microlentille, qui sera ensuite transféré dans la couche de silice 301 sous-jacente.

L'épaisseur de résine à déposer peut varier en fonction des conditions de gravure utilisées pour le transfert du motif de microlentille dans la couche de silice 301.

La couche de résine photosensible 31 est d'abord structurée par lithographie (figure 20C) de façon à obtenir une partie 310 de résine centrée vis-à-vis de l'ouverture 400 de la couche de réflexion 40.

Cette partie 310 présente une largeur environ égale à celle de la microlentille 300.

Un traitement thermique de cette partie 310 peut ensuite permettre de générer le motif 311 de microlentille (figure 20E). Un tel traitement thermique peut être adapté en fonction des propriétés de viscosité et/ou de tension de surface de la résine photosensible.

Une gravure anisotrope, selon une direction normale à la couche de silice 301, est ensuite effectuée de façon à transférer ce motif 311 de microlentille dans la couche de silice 301.

La microlentille 300 est ainsi formée dans la couche de silice 301 (figure 20G).

Cette gravure peut avantageusement présenter une sélectivité de 1:1 entre la résine et la silice. Le motif 311 est dès lors transféré directement dans la couche de silice 301. La courbure initiale du motif 311 en résine peut ainsi être fidèlement reproduite sur la microlentille 300. La hauteur de la microlentille 300 est sensiblement la même que la hauteur du motif 311.

Une microlentille 300 en nitrure de silicium (SiN) peut également être réalisée selon le même principe, à partir d'une couche 301 en SiN. En fonction du contraste d'indice recherché entre la microlentille et le milieu environnant, d'autres matériaux peuvent être utilisés pour former la microlentille 300.

Selon un autre exemple, un motif 311 peut être formé par dispense localisée de résine sur une surface 302 hydrophile.

Selon cette alternative, un masque 312 est formé sur la surface 302 de la couche de silice 301 (figure 20D) avant dispense de la résine. Ce masque 312 permet de confiner l'étalement de la résine au niveau du motif 311.

L'épaisseur du masque 312 est de préférence au moins deux fois inférieure, et de préférence au moins cinq fois inférieure à la hauteur du motif 311. Cela permet d'éviter des effets capillaires en bordure du motif 311, de nature à modifier la courbure du motif 311.

Dans cet exemple, la surface 302 est fonctionnalisée de façon à la rendre hydrophile. Cela permet de modifier la tension de surface entre la surface 302 et la résine, de façon à obtenir la courbure souhaitée pour le motif 311 (figure 20F).

Le motif 311 est ensuite transféré par gravure dans la couche de silice 301, comme précédemment.

La microlentille 300 est ainsi formée dans la couche de silice 301 (figure 20G).

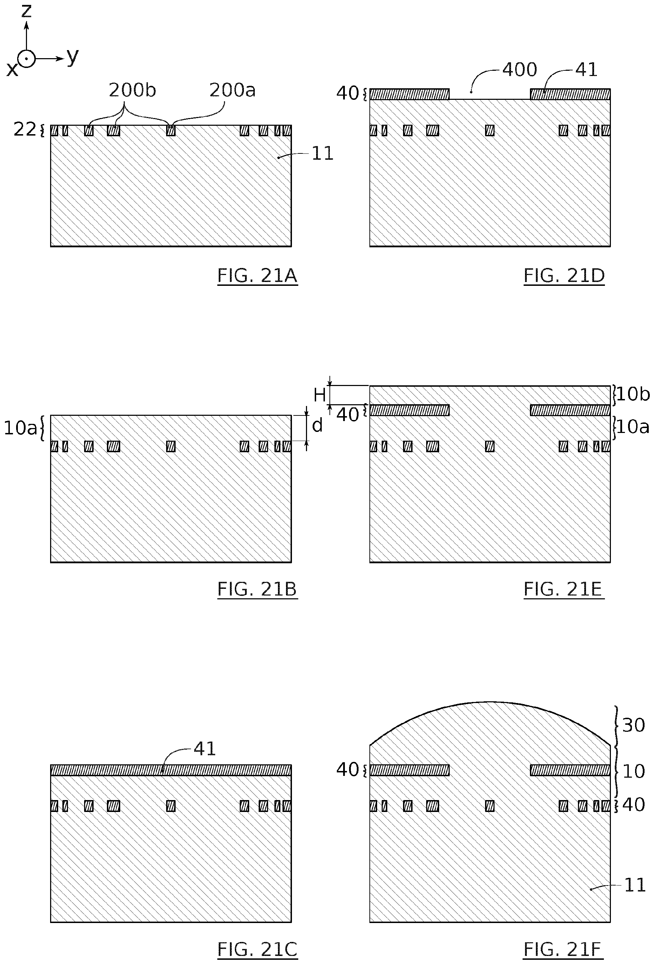

Les figures 21A à 21F illustrent la réalisation d'un diffuseur comprenant au moins une nanostructure métallique, une couche de réflexion ouverte en regard de l'au moins une nanostructure, et une microlentille réfractive conjuguée à l'au moins une nanostructure.

Une couche de diffusion 22 comprenant au moins une nanostructure 200a ou une pluralité de nanostructures métalliques 200a, 200b est réalisée sur un substrat 11 transparent par lithographie/gravure et planarisée, comme précédemment (figure 21A).

Une première partie 10a de la couche de transmission 10 en silice est déposée sur la face planarisée de la couche de diffusion 22, sur une épaisseur d (figure 21B).

Une couche de métal 41, par exemple en aluminium, est déposée sur la première partie 10a de la couche de transmission 10. Cette couche de métal 41 présente de préférence une épaisseur comprise entre 50 nm et 300 nm.

Une ouverture 400 alignée sur l'au moins une nanostructure 200a est formée dans la couche de métal 41 par lithographie et gravure (figure 21D). Cette ouverture 400 présente un diamètre W.

La couche de réflexion 40 est ainsi formée.

Un dépôt de silice est ensuite effectué de manière à remplir l'ouverture 400 et à former une deuxième partie 10b de la couche de transmission 10 (figure 21E).

Cette deuxième partie 10b présente une épaisseur H.

Une couche de transmission 10 comprenant en son sein une couche de réflexion 40 est ainsi formée.

Une couche de focalisation 30 comprenant une microlentille 300 est ensuite réalisée comme précédemment (figure 21F).

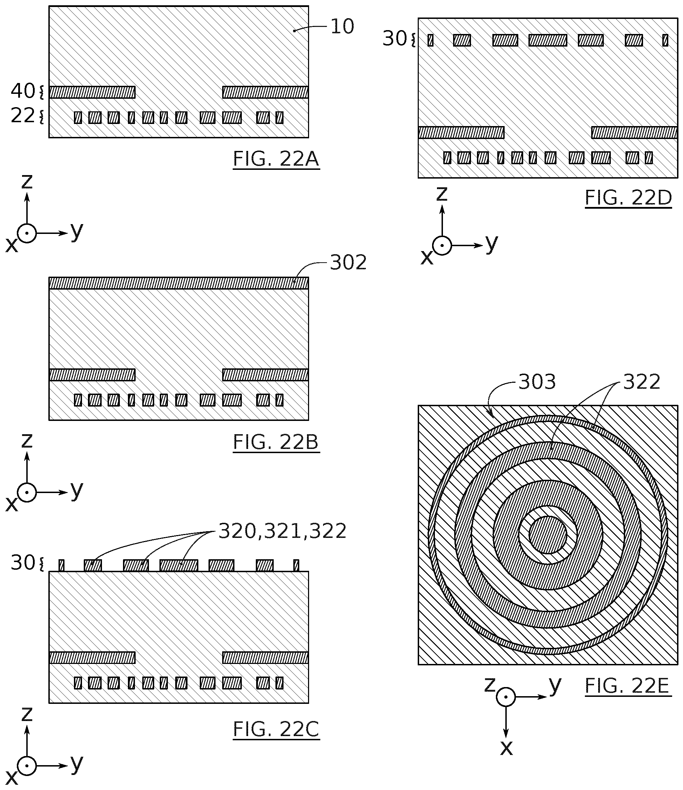

Les figures 22A à 22E illustrent la réalisation d'un diffuseur comprenant au moins une nanostructure métallique 200a, une couche de réflexion 40 ouverte en regard de l'au moins une nanostructure 200a, et une lentille de Fresnel 303 conjuguée à l'au moins une nanostructure 200a.

Comme précédemment, une couche de diffusion 22 et une couche de transmission 10 comprenant en son sein une couche de réflexion 40 sont formées (figure 22A).

Une couche de métal 302, par exemple en aluminium, est déposée sur la face exposée de la couche de transmission 10. Cette couche de métal 302 présente de préférence une épaisseur comprise entre 50 nm et 300 nm (figure 22B).

Des motifs 320, 321, 322 de lentille de Fresnel sont formés dans cette couche de métal 302, de préférence par lithographie / gravure, de façon à former la couche de focalisation 30 (figure 22C).

De façon optionnelle, une étape de planarisation comprenant un dépôt de silice entre les motifs 320, 321, 322 et/ou un polissage, peut également être réalisée (figure 22D). La couche de focalisation 30 est ainsi protégée et présente une tenue mécanique améliorée.

Une telle lentille de Fresnel 303 comprenant par exemple des motifs 322 en anneaux concentriques de largeurs décroissantes depuis le centre est illustrée à la figure 22E.

Les largeurs d'anneaux et les espacements entre anneaux sont choisis de façon à obtenir la distance focale souhaitée, qui correspond sensiblement à l'épaisseur H + d de la couche de transmission 10.

La lentille de Fresnel peut donc être avantageusement réalisée par des technologies planaires standard de la microélectronique (dépôt, lithographie, gravure).

Une telle couche de focalisation 30 est simple à réaliser.

Exemple de système

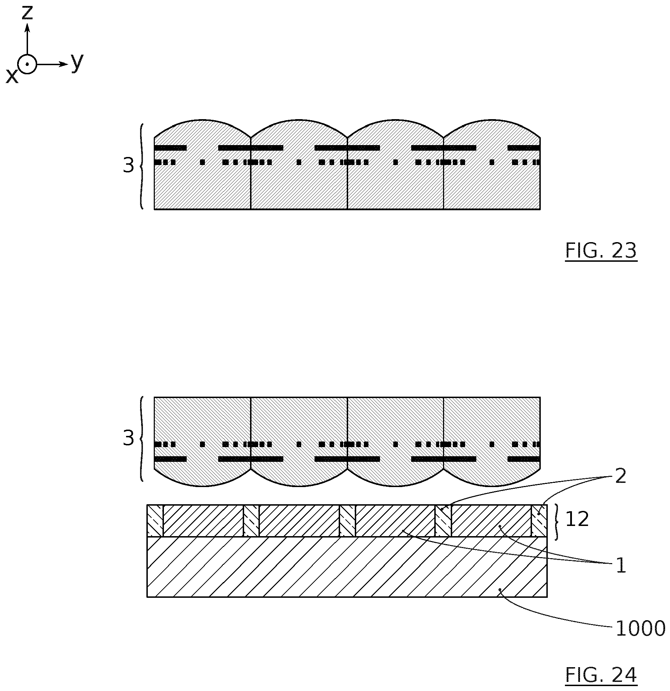

La présente invention concerne également un système associant au moins une source de lumière, de préférence une pluralité de sources de lumière ponctuelles, à une pluralité de diffuseurs tel que décrits au travers des exemples de réalisation précédents. Un tel système est décrit ci-après en référence aux figures 23 et 24.

Un tel système comprend une pluralité de diffuseurs 3 adjacents les uns aux autres. Ces diffuseurs 3 s'étendent selon un plan parallèle au plan d'extension principal xy. Cette pluralité de diffuseurs 3 peut être réalisée par des technologies planaires standard de la microélectronique, selon les architectures et procédés décrits précédemment.

Cette pluralité de diffuseurs 3 peut par exemple comprendre des diffuseurs comprenant chacun un support transparent 11, une couche de transmission 10, une couche de réflexion 40, une couche de diffusion 22 à base d'au moins une nanostructure métallique, et une couche de focalisation 30 comprenant une microlentille réfractive (figure 23).

Selon une possibilité non illustrée, les microlentilles réfractives peuvent être en SiN et protégées par une couche de silice planarisée.

La pluralité de diffuseurs 3 peut ensuite être agencée en regard de sources de lumière ponctuelles 1, par exemple des LED (figure 24)

Les LED 1 peuvent être séparées entre elles par des structures 2 d'isolation et/ou d'injection électrique.

Les LED 1 sont de préférence commandées indépendamment les unes des autres par une matrice de commande 1000, intégrant par exemple des composants CMOS (Complementary Metal Oxide Semiconductor).

Ces LED 1 forment par exemple les pixels ou les sous-pixels d'un écran d'affichage.

L'assemblage entre la pluralité de diffuseurs 3 et la pluralité de sources ponctuelles 12 peut se faire par couplage classique avec alignement, par exemple à l'aide d'une machine d'hybridation dite « Die-to-wafer ». La cohésion de l'assemblage est assurée par exemple par une colle dont l'indice de réfraction ne perturbe pas le fonctionnement des lentilles de la couche de focalisation. Cette colle peut être par exemple une colle UV.

Selon une possibilité, des espaceurs peuvent être disposés entre la pluralité de diffuseurs 3 et la pluralité de sources ponctuelles 12, de façon à fixer la distance de séparation entre ces deux parties 3, 12 en regard l'une de l'autre.

Le système selon l'invention associant une pluralité de sources de lumière ponctuelles à une pluralité de diffuseurs trouve pour application avantageuse la réalisation d'écrans d'affichage à trois dimensions (3D).

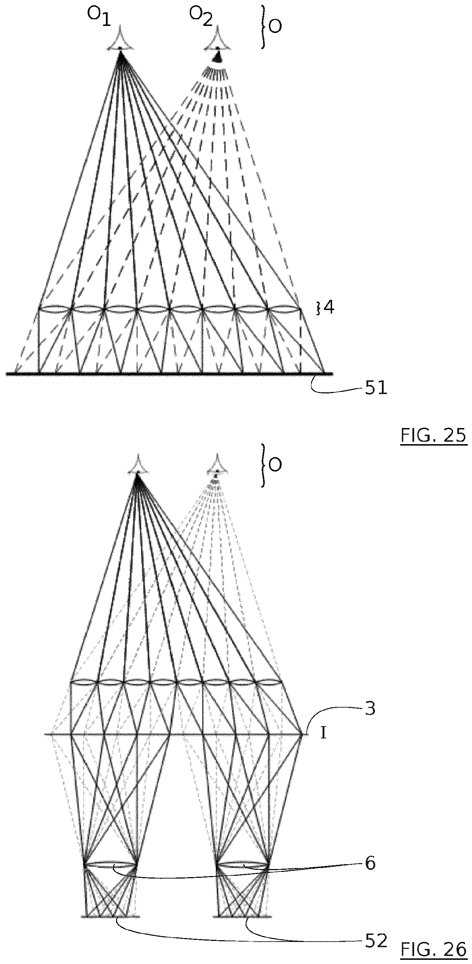

De tels écrans d'affichage 3D sont conçus de sorte à afficher des images légèrement différentes suivant l'angle de vue. En particulier, pour donner une perception tridimensionnelle à un observateur O, il faut que chacun de ses deux yeux O1, O2 voient deux images légèrement différentes par exemple en termes de luminosité et/ou de couleur (figure 25).

De façon connue, un écran 3D peut être réalisé en combinant une matrice de microlentilles 4 et un écran 51 à très haute résolution, tel qu'illustré à la figure 25. Dans une telle configuration, l'observateur O voit l'écran 51 haute résolution au travers de la matrice de microlentilles 4. En particulier, le premier œil de l'observateur O1 voit au travers de la matrice de microlentilles une première série de petites zones de l'écran haute résolution, formant une première image. Le deuxième œil de l'observateur O2 voit au travers de la matrice de microlentilles une deuxième série de petites zones de l'écran haute résolution, formant une deuxième image. Ces première et deuxième séries sont entrelacées au sein de l'écran 51 haute résolution.

Pour que l'observateur O puisse se placer arbitrairement dans une position donnée devant l'écran 3D, le système génère des images différentes pour une multitude de points de vue situés les uns à côté des autres. On appelle couramment « vues » (views en anglais), ces points de vue. À une position donnée par rapport à l'écran 3D, les yeux O1, O2 de l'observateur sélectionnent deux vues différentes qui, en se combinant, donnent une perception tridimensionnelle à l'observateur. Lorsque celui-ci déplace sa tête par rapport à l'écran 3D, cette sélection change, ce qui augmente encore la perception 3D.

En pratique, les petites zones des différentes séries correspondent à des pixels de l'écran 51 à très haute résolution. Ces pixels forment des sources de lumière ponctuelles. Ils peuvent être constitués par une ou plusieurs LED 1 par exemple. Le nombre de pixels de l'écran à très haute résolution est dans le cas d'une application à l'affichage 3D le produit du nombre de microlentilles 4 (correspondant à la résolution nominale de l'écran 3D perçue par l'observateur) par le nombre de vues (correspondant aux placements possibles de l'observateur vis-à-vis de l'écran 3D). Pour une même résolution nominale, le nombre de pixel nécessaires à la réalisation d'un écran 3D est donc très supérieur à celui d'un écran 2D, du fait du nombre de vues. Un tel système requiert donc d'utiliser un écran 51 interne de très haute résolution, pour obtenir *in fine* la résolution nominale souhaitée en affichage 3D. Un écran 51 à très haute résolution présente typiquement une densité de pixels supérieure ou égale à 500 ppi (acronyme de « pixels per inch » ou pixels par pouce en français), et/ou un pas de pixel inférieur ou égal à 50 $\mu$m. Un écran 51 à très haute résolution présente typiquement un nombre de pixels supérieur ou égal à 10 Mp (mégapixels, soit $10^6$ pixels).

Cet écran 51 interne de très haute résolution entremêlant une pluralité d'images associées au nombre de vues souhaitées peut être réalisé ou remplacé par une pluralité de micro-écrans 52 internes diffusant chacun une partie des images requises. Dans ce cas, chacun des micro-écrans 52 est associé à un système de projection 6. La figure 26 illustre un tel système associant des micro-écrans 52 et des systèmes de projection 6. Par souci de clarté, seuls deux micro-écrans 52 et deux systèmes de projection 6 sont illustrés sur cette figure 26.

Pour que les rayons lumineux issus des bords d'un micro-écran 52 soient dirigés en direction de l'observateur O, il est nécessaire de placer un diffuseur 3 dans le plan image I conjugué au plan dans lequel se trouve le micro-écran 52.

Un tel diffuseur 3 doit être efficace à l'échelle des pixels de l'écran 51 à très haute résolution ou des pixels de la pluralité de micro-écrans 52. Ces pixels présentent typiquement une taille d'environ 15 μm. Le diffuseur 3 revendiqué par la présente invention permet avantageusement d'obtenir l'efficacité requise dans le cadre de cette application pour l'affichage 3D.

Dès lors, un système selon l'invention comprenant :

-   un écran 51 à très haute résolution constitué d'une pluralité de micro-écrans 52 comprenant chacun une pluralité de pixels,
-   une pluralité de systèmes de projection 6 associée à la pluralité de micro-écrans 52,
-   une pluralité de diffuseurs 3 tels que décrits par la présente invention, chaque diffuseur 3 étant associé à chaque pixel des pluralités de pixels des micro-écrans 52, et
-   une matrice de microlentilles 4,

est particulièrement avantageux pour l'affichage 3D.

Un exemple non limitatif de dimensionnement d'un tel système est décrit ci-après.

Pour une taille d'écran 3D de 195 mm x 150 mm de diagonale 246 mm (9,6 pouces) affichant une résolution de 1300 x 1000, le pas perçu par l'utilisateur est de 150μm (ce qui correspond à la taille d'une microlentille 4 de la matrice de microlentilles). Pour obtenir 10X10 vues, l'écran 51 à très haute résolution doit alors avoir 13000 x 10000 pixels, au pas de 15 μm. Chaque pixel présente ainsi une taille d'environ 15μm.

L'écran 51 à très haute résolution peut être réalisé en pratique en assemblant 5 x 5 micro-écrans 52 ayant chacun 2600 x 2000 pixels. De tels micro-écrans 52 sont par exemple commercialisés par la société microOLED.

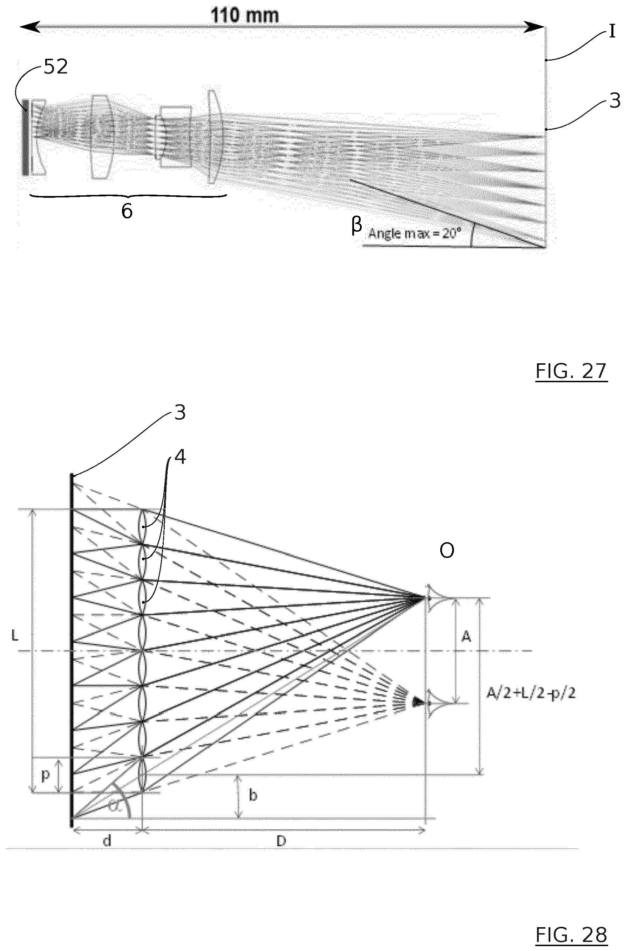

Le système de projection 6 peut être réalisé selon le design optique illustré à la figure 27. Il permet par exemple de former une image du micro-écran 52 sur un plan image I situé à 110 mm du micro-écran 52. L'angle d'incidence β maximal est dans ce cas d'environ 20° par rapport à la normale au plan image I. Tel que montré précédemment, le diffuseur 3 selon l'invention peut transmettre efficacement une lumière incidente dans un cône d'émission présentant un tel angle d'incidence β de l'ordre de 20°.

L'image formée sur le plan image I est alors diffusée par les diffuseurs 3 puis focalisée par la matrice de microlentilles 4.

Tel qu'illustré à la figure 28, pour un écran de largeur L et pour un observateur situé à une distance D ayant des yeux espacés de A, l'angle maximal α admissible par les microlentilles 4 peut être approximativement déterminé par :

$$tan\,\alpha \approx \frac{A + L/2}{D}$$

Soit, pour L = 195 mm (largeur typique d'une tablette), D = 50 cm (distance typique d'observation d'une tablette) et A = 10 cm, α ≈ 21,5°.

Les angles α et β sont de signes opposés. Le diffuseur 3 est donc configuré de sorte à présenter un diagramme angulaire présentant un angle de diffusion maximal d'environ 40°. Tel que montré précédemment, le diffuseur 3 selon l'invention permet d'obtenir un tel diagramme angulaire.

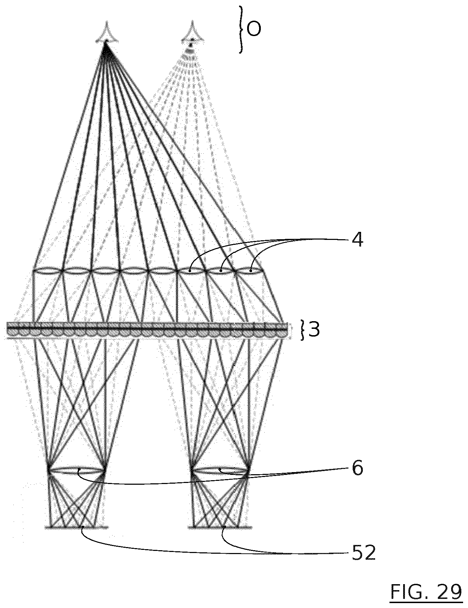

Un système d'affichage 3D fonctionnel et efficace peut donc être avantageusement réalisé en bénéficiant du diffuseur 3 décrit dans la présente invention, tel qu'illustré à la figure 29.

L'invention n'est pas limitée aux modes de réalisations précédemment décrits et s'étend à tous les modes de réalisation couverts par les revendications.

## Revendications

**1.** Diffuseur (3) destiné à recevoir de la lumière émise par une source de lumière (1) visible comprenant une couche de transmission (10) transparente à la lumière émise et une couche de diffusion (22, 23) destinée à diffuser ladite lumière, le diffuseur (3) étant **caractérisé en ce que** la couche de diffusion (22, 23) comprend une pluralité de nanostructures métalliques (200, 200a, 200b) présentant chacune, en projection dans un plan d'extension principal (xy), des première et deuxième dimensions (L1, L2) selon respectivement des première (y) et deuxième (x) directions orthogonales du plan d'extension principal (xy), lesdites première et deuxième dimensions (L1, L2) étant inférieures à 650 nm, lesdites nanostructures métalliques (200, 200a, 200b) étant réparties sur la couche de transmission (10) de sorte que des nanostructures métalliques adjacentes (200i, 200j) présentent entre elles des distances de séparation (dij) variées et lesdites nanostructures métalliques (200, 200a, 200b) étant dimensionnées de sorte à présenter entre elles des dimensions variées parmi les premières et les deuxièmes dimensions (L1, L2).

**2.** Diffuseur (3) selon la revendication précédente dans lequel au moins certaines des nanostructures métalliques adjacentes (200i, 200j) présentent des distances de séparation (dij) inférieures à 500 nm, et au moins certaines autres des nanostructures métalliques adjacentes (200i, 200j) présentent des distances de séparation (dij) supérieures à 600 nm.

3. Diffuseur (3) selon l'une quelconque des revendications précédentes dans lequel, pour une même nanostructure, les première et deuxième dimensions (L1, L2) sont sensiblement égales entre elles.

4. Diffuseur (3) selon l'une quelconque des revendications précédentes dans lequel pour au moins certaines nanostructures (200) lesdites dimensions variées prises parmi les premières et les deuxièmes dimensions (L1, L2) sont inférieures à 250 nm, et pour au moins certaines autres nanostructures métalliques lesdites dimensions variées prises parmi les premières et les deuxièmes dimensions (L1, L2) sont supérieures à 350 nm.

5. Diffuseur (3) selon l'une quelconque des revendications précédentes comprenant en outre au moins une couche de focalisation (30) configurée pour focaliser la lumière émise sur au moins une nanostructure métallique (200a, 201) de la pluralité de nanostructures métalliques.

6. Diffuseur (3) selon la revendication précédente dans lequel la couche de focalisation (30) comprend au moins l'une parmi une microlentille réfractive (300) et une lentille de Fresnel (303).

7. Diffuseur (3) selon l'une quelconque des deux revendications précédentes comprenant en outre au moins une couche de réflexion (40) située entre la couche de diffusion (22) et la couche de focalisation (30) au sein de la couche de transmission (10), ladite couche de réflexion (40) présentant au moins une ouverture (400) en regard de l'au moins une nanostructure métallique (200a) sur laquelle la lumière émise est focalisée.

8. Diffuseur (3) selon la revendication précédente dans lequel l'ouverture présente en projection dans le plan d'extension principal une dimension d'extension principale W telle que : $W \geq \frac{D.d}{H+d}$ où D est une dimension d'extension principale du diffuseur (3), d est une distance séparant la couche de diffusion (22, 23) de la couche de réflexion (40), H est une distance séparant la couche de réflexion (40) de la couche de focalisation (30).

9. Diffuseur (3) selon l'une quelconque des revendications précédentes dans lequel au moins une partie des nanostructures métalliques (200, 200a, 200b) sont en au moins un métal pris parmi l'aluminium, le tungstène, le cuivre, l'argent, l'or.

10. Système d'affichage comprenant au moins un diffuseur (3) selon l'une quelconque des revendications précédentes et au moins une source de lumière ponctuelle (1), dans lequel l'au moins un diffuseur (3) est configuré pour coopérer avec l'au moins une source de lumière ponctuelle (1) de façon à diffuser une lumière émise par celle-ci.

11. Système d'affichage selon la revendication précédente comprenant :

   - un écran (51), de préférence à très haute résolution, comprenant une pluralité de micro-écrans (52) comprenant chacun une pluralité de pixels,
   - une pluralité de systèmes de projection (6) associée à la pluralité de micro-écrans (52),
   - une pluralité de diffuseurs (3) selon l'une quelconque des revendications 1 à 14, chaque diffuseur (3) étant associé à au moins un pixel des pluralités de pixels des micro-écrans (52), et
   - une matrice de microlentilles (4) associée à la pluralité de diffuseurs (3).

12. Procédé de fabrication d'un diffuseur (3) comprenant au moins une couche de diffusion (22) destinée à diffuser une lumière émise par une source de lumière (1) visible et comprenant une pluralité de nanostructures métalliques (200), ledit procédé comprenant au moins les étapes suivantes :

   - Fournir un support (11) en un matériau transparent à la lumière émise et présentant une face de support (110),
   - Former sur la face de support (110) ladite pluralité de nanostructures métalliques (200) présentant chacune, en projection dans un plan d'extension principal (xy) parallèle à la face de support (110), des première et deuxième dimensions (L1, L2) selon respectivement des première (y) et deuxième (x) directions orthogonales du plan d'extension principal (xy), lesdites première et deuxième dimensions étant inférieures à 650 nm, lesdites nanostructures métalliques (200) étant réparties sur le support (11) de sorte que des nanostructures métalliques adjacentes (200i, 200j) présentent entre elles des distances de séparation (dij) variées et lesdites nanostructures métalliques (200, 200a, 200b) étant dimensionnées de sorte à présenter entre elles des dimensions variées parmi les premières et les deuxièmes dimensions (L1, L2).

13. Procédé selon la revendication précédente comprenant en outre :

**EP 3 798 695 A1**

- une étape de dépôt sur la pluralité de nanostructures métalliques (200) d'un matériau transparent à la lumière émise et enveloppant les nanostructures métalliques (200), puis
- une étape de planarisation configurée pour former une couche de diffusion (22) composite comprenant le matériau transparent à la lumière émise enveloppant les nanostructures métalliques (200), ladite couche de diffusion (22) composite présentant une face planarisée (220).

**14.** Procédé selon la revendication précédente comprenant en outre la formation d'une couche de transmission (10) sur la face planarisée (220), ladite couche de transmission (10) présentant une face de transmission (100) opposée à la face planarisée (220) et destinée à être en regard de la source de lumière (1), le procédé comprenant en outre la formation d'une couche de focalisation (30) s'étendant sur ladite face de transmission (100), ladite couche de focalisation (30) étant configurée pour focaliser la lumière émise sur au moins une nanostructure métallique (200a) de la pluralité de nanostructures métalliques (200).

**15.** Procédé selon la revendication précédente comprenant en outre la formation d'une couche de réflexion (40) au sein de la couche de transmission (10), entre la couche de diffusion (22) et la couche de focalisation (30), ladite couche de réflexion (40) présentant au moins une ouverture (400) en regard de l'au moins une nanostructure métallique (200a) sur laquelle la lumière émise est destinée à être focalisée par la couche de focalisation (30).

FIG. 1A

FIG. 1B

FIG. 2A

FIG. 2B

FIG. 2C

FIG. 3A

FIG. 3B

FIG. 3C

FIG. 4A

FIG. 4B

FIG. 4C

FIG. 5A

FIG. 5B

FIG. 5C

FIG. 6A

FIG. 6B

FIG. 6C

FIG. 7A

FIG. 7B

FIG. 7C

FIG. 8A

FIG. 8B

FIG. 8C

FIG. 9A

FIG. 9B

320

FIG. 10C

201, 200a 23
10
30

FIG. 10A

321

FIG. 10D

320, 321, 322
201, 200a 23
10
30

FIG. 10B

322

FIG. 10E

FIG. 11

FIG. 12

FIG. 13A

FIG. 13B

FIG. 13C

FIG. 14A

FIG. 14B

FIG. 14C

λ=650nm

<u>FIG. 15A</u>

<u>FIG. 15B</u>

<u>FIG. 15C</u>

FIG. 16A

FIG. 16B

FIG. 16C

FIG. 16D

FIG. 17A

FIG. 17B

FIG. 17C

FIG. 17D

z

x → y

110

11

FIG. 18A

12

11

FIG. 18B

200

11

}22

FIG. 18C

220

200

11

}22

FIG. 18D

201 — 230

11

}23

FIG. 19A

H

}10

}23

11

FIG. 19B

300

}30

}10

}23

FIG. 19C

z

y

x

100

10

40

22

FIG. 20A

31

301

100

10

FIG. 20B

310

301

100

400

40

FIG. 20C

312

FIG. 20D

311

FIG. 20E

311

312

FIG. 20F

300

100

10

30

400

40

22

FIG. 20G

z

x ⊙ → y

200b    200a

22{

11

FIG. 21A

10a{

FIG. 21B

41

FIG. 21C

40{    400    41

FIG. 21D

H

40{    }10b

}10a

d

FIG. 21E

30

40{    10

40

11

FIG. 21F

FIG. 22A

FIG. 22B

FIG. 22C

FIG. 22D

FIG. 22E

FIG. 23

FIG. 24

FIG. 25

FIG. 26

FIG. 27

FIG. 28

FIG. 29

**Europäisches Patentamt**
**European Patent Office**
**Office européen des brevets**

# RAPPORT DE RECHERCHE EUROPEENNE

Numéro de la demande

EP 20 19 8212

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2011/170184 A1 (WOLK MARTIN B [US]) 14 juillet 2011 (2011-07-14) * abrégé * * paragraphes [0038]-[0039], [0046]-[0053], [0059]-[0060], [0062]-[0069], [0075]-[0086], [0090], [0114]-[0116], [0123]-[0128], [0136], [0140]-[0151], [0156]-[0163] * * figures 1-23 * | 1-15 | INV. G02B5/02 B82Y20/00 |
| X | US 2015/167921 A1 (GOLLIER JACQUES [US] ET AL) 18 juin 2015 (2015-06-18) * abrégé * * paragraphes [0005], [0006], [0045]-[0047], [0067]-[0069], [0072]-[0073], [0092]-[0093], [0097]-[0098] * * figures 1-24 * | 1,10,12 | |

DOMAINES TECHNIQUES RECHERCHES (IPC)

G02B
B82Y
G01N
F21Y

Le présent rapport a été établi pour toutes les revendications

| Lieu de la recherche | Date d'achèvement de la recherche | Examinateur |
|---|---|---|
| Munich | 2 février 2021 | Kienle, Philipp |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 20 19 8212

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-02-2021

| Document brevet cité au rapport de recherche | | Date de publication | Membre(s) de la famille de brevet(s) | | Date de publication |
|---|---|---|---|---|---|
| US 2011170184 | A1 | 14-07-2011 | CN | 102822708 A | 12-12-2012 |
| | | | EP | 2524256 A1 | 21-11-2012 |
| | | | JP | 2013517528 A | 16-05-2013 |
| | | | KR | 20120115541 A | 18-10-2012 |
| | | | US | 2011170184 A1 | 14-07-2011 |
| | | | WO | 2011087958 A1 | 21-07-2011 |
| US 2015167921 | A1 | 18-06-2015 | CN | 106461812 A | 22-02-2017 |
| | | | EP | 3080646 A1 | 19-10-2016 |
| | | | JP | 6564376 B2 | 21-08-2019 |
| | | | JP | 2017503312 A | 26-01-2017 |
| | | | KR | 20160097335 A | 17-08-2016 |
| | | | TW | 201530195 A | 01-08-2015 |
| | | | US | 2015167921 A1 | 18-06-2015 |
| | | | WO | 2015089147 A1 | 18-06-2015 |

EPO FORM P0460

Pour tout renseignement concernant cette annexe : voir Journal Officiel de l'Office européen des brevets, No.12/82